# EUROPÄISCHE PATENTSCHRIFT

(11) **EP 3 166 228 B1**
(45) Veröffentlichungstag und Bekanntmachung des Hinweises auf die Patenterteilung: **11.05.2022**
(21) Anmeldenummer: 16002286.9
(22) Anmeldetag: 26.10.2016
(51) Int. Cl.: H03K 17/955, G06F 3/044, H03K 17/975, H03K 17/98

(54) **SENSORMODUL, SENSORSYSTEM UND VERFAHREN ZUM KAPAZITIVEN UND ORTSAUFGELÖSTEN DETEKTIEREN EINER ANNÄHERUNG UND BERÜHRUNG, VERWENDUNG DES SENSORMODULS**
SENSOR MODULE, SENSOR SYSTEM AND METHOD FOR CAPACITIVE AND SPATIALLY RESOLVED DETECTION OF APPROACHING AND CONTACT, USE OF THE SENSOR MODULE
MODULE CAPTEUR, SYSTÈME DE CAPTEUR ET PROCÉDÉ DE DÉTECTION CAPACITIF ET À RÉSOLUTION SPATIALE D'UNE APPROCHE ET MISE EN CONTACT, UTILISATION DU MODULE CAPTEUR

(30) Priorität: 05.11.2015 DE 102015014317
(43) Veröffentlichungstag der Anmeldung: 10.05.2017
(73) Patentinhaber: Karlsruher Institut für Technologie, 76131 Karlsruhe (DE)
(72) Erfinder: Escaida Navarro, Stefan, 76131 Karlsruhe (DE); Alagi, Hosam, 76131 Karlsruhe (DE); Mende, Michael, 68723 Plankstadt (DE); Hein, Björn, 76133 Karlsruhe (DE)
(74) Vertreter: Müller-Boré & Partner Patentanwälte PartG mbB

(56) Entgegenhaltungen:
- EP-A1- 2 833 551
- WO-A2-2011/130755
- US-A1- 2008 202 251
- US-A1- 2011 043 227

## Beschreibung

Die Erfindung betrifft ein Sensormodul, ein Sensorsystem und ein Verfahren zum kapazitiven und ortsaufgelösten Detektieren der Annäherung von Objekten an das Sensormodul und zum kapazitiven und ortsaufgelösten Erfassen von taktilen Ereignissen zwischen Objekten und dem Sensormodul. Zudem betrifft die Erfindung eine Verwendung des Sensormoduls oder des Sensorsystems.

Kapazitive Sensoren werden mittlerweile in vielen Anwendungsgebieten, wie z.B. in der Unterhaltungs- und Consumer-Elektronik, aber auch in der Industrie eingesetzt, um Annäherungsereignisse und/oder taktile Ereignisse, d.h. Kontakt- bzw. Berührungsereignisse, zu detektieren. Insbesondere in der Robotik spielen kapazitive Sensoren eine wichtige Rolle, gerade wenn es darum geht, Sensoren zu entwickeln, mit denen Maschinen ihre Aufgaben intelligenter erledigen und ihre Umgebung interaktiver erkunden können. Auch die Gewährleistung der Sicherheit des Menschen bei einer Mensch-Roboter-Kooperation ist hierbei von entscheidender Bedeutung.

Um sowohl Annäherungsmessungen als auch taktile Messungen mit einem einzigen Sensor zu realisieren, ist in der Druckschrift DE 10 2010 049 484 A1 ein taktiler Näherungssensor offenbart. Dieser Näherungssensor ist zur Erfassung der Annäherung von Objekten an den Sensor sowie zur Erfassung von Druckprofilen geeignet. Während die Erfassung von Druckprofilen ortsaufgelöst erfolgen kann, so ist die Erfassung von Annäherungen von Objekten an den Sensor nur global, d.h. nicht ortsaufgelöst, möglich. Zudem weist der in der Druckschrift DE 10 2010 049 484 A1 beschriebene Sensor mindestens fünf Schichten auf, wobei mindestens drei dieser Schichten elektrisch leitfähige Schichten sind. Dies führt dazu, dass der Sensor relativ komplex aufgebaut ist, was einerseits einen großen Platzbedarf und andererseits hohe Material- bzw. Herstellungskosten mit sich bringt.

Die Druckschrift WO 2011/130755 A2 offenbart ein Benutzer-Interface zum Detektieren sowohl einer Annäherung als auch einer Berührung, wobei das Benutzer-Interface eine Sensorplatte aufweist, die mit einem elektrisch leitfähigen und relativ zur Sensorplatte beweglichen Cover umgeben ist. Um ferner eine Abschirmung zu implementieren, sind zusätzliche elektrisch leitfähige Schichten notwendig.

Es ist daher eine Aufgabe der vorliegenden Erfindung, ein kompaktes und in der Herstellung kostengünstiges Sensormodul bereitzustellen, welches geeignet ist, sowohl die Annäherung von Objekten an das Sensormodul sowie die Erfassung von taktilen Ereignissen zwischen Objekten und dem Sensormodul ortsaufgelöst zu detektieren. Darüber hinaus ist es eine Aufgabe der vorliegenden Erfindung ein diesbezügliches Verfahren und eine Verwendung des Sensormoduls anzugeben.

Diese Aufgabe wird durch die Gegenstände der nebengeordneten Ansprüche gelöst. Vorteilhafte Ausführungsformen sind Gegenstand der Unteransprüche.

Ein erster unabhängiger Aspekt zur Lösung der Aufgabe betrifft ein Sensormodul zum kapazitiven und ortsaufgelösten Detektieren der Annäherung eines Objektes an das Sensormodul und zum kapazitiven und ortsaufgelösten Erfassen von taktilen Ereignissen zwischen einem Objekt und dem Sensormodul, umfassend
- ein Sensorelement, welches eine erste, zweite und dritte Schicht aufweist, wobei die erste Schicht eine Vielzahl von elektrisch leitfähigen Deckelelektroden umfasst, wobei die zweite Schicht verformbar und elektrisch isolierend ist, wobei die dritte Schicht eine elektrisch leitfähige Bodenelektrode aufweist, wobei die zweite Schicht zwischen der ersten und dritten Schicht angeordnet ist, wobei die erste und dritte Schicht die einzigen elektrisch leitfähigen Schichten des Sensorelements sind, und
- eine Messeinheit, welche ausgelegt ist, das Sensorelement in drei verschiedenen Mess-Konfigurationen, nämlich in einer selbst-kapazitiven Annäherungskonfiguration, einer beidseitig-kapazitiven Annäherungskonfiguration und einer beidseitig-kapazitiven Taktilitätskonfiguration, zu betreiben, wobei die Messeinheit ausgelegt ist:
   -- in der selbst-kapazitiven Annäherungskonfiguration zumindest eine der Deckelektroden in einem Sendemodus zu betreiben;
   -- in der beidseitig-kapazitiven Annäherungskonfiguration die zumindest eine Deckelektrode im Sendemodus oder in einem Empfangsmodus zu betreiben; und
   -- in der beidseitig-kapazitiven Taktilitätskonfiguration die zumindest eine Deckelelektrode im Sendemodus und die Bodenelektrode im Empfangsmodus zu betreiben.

Unter einem Sensormodul wird insbesondere ein Sensor verstanden, der modular aufgebaut ist, d.h. der auch mit weiteren Sensoren verbunden, gekoppelt, kontaktiert und/oder zusammengesteckt werden kann, um dadurch eine beliebige Sensorfläche auszubilden.

Unter einem kapazitiven Detektieren wird verstanden, dass Messwerte mit Hilfe einer Kapazitätsmessung bzw. einer Kapazitätsänderungsmessung erfasst werden können.

Unter einem ortsaufgelösten Detektieren wird verstanden, dass ein Ereignis, d.h. eine Annäherung und/oder ein Kontakt bzw. eine Berührung, nicht nur festgestellt, sondern auch innerhalb einer Fläche des Sensormoduls lokalisiert werden kann. Treten mehrere Ereignisse auf, beispielsweise gleichzeitig, so bedeutet ein ortsaufgelöstes Detektieren, dass alle Ereignisse getrennt und unabhängig voneinander lokalisierbar sind.

Unter der Detektion bzw. Erfassung einer Annäherung wird insbesondere die Wahrnehmung von Ereignissen um den Sensor bzw. das Sensormodul verstanden. Dabei kann die Reichweite dieser Wahrnehmung vorzugsweise von 0 mm bis 100 mm sein. Die Reichweite kann aber, je nach Anwendung, auch größer sein. Unter der Detektion bzw. Erfassung von taktilen Ereignissen, d.h. von Kontakten bzw. Berührungen, wird im Sinne dieser Erfindung ein kraftauflösendes Wahrnehmen von Taktilität bzw. Berührungsereignissen verstanden. Die Detektion von taktilen Ereignissen erfolgt insbesondere unabhängig von der Detektion einer Annäherung.

Ein Objekt kann ein beliebiger Gegenstand oder Körper und insbesondere auch ein Lebewesen wie z.B. ein Mensch sein. Ein Objekt kann auch ein Körperteil eines Lebewesens wie z.B. eine Hand oder ein Finger eines Menschen sein.

Das Sensorelement weist drei Schichten oder Lagen auf. Dabei ist die erste Schicht leitfähig und umfasst eine Vielzahl von Deckelelektroden. Insbesondere wird die erste Schicht aus einer Vielzahl von Deckelelektroden gebildet. Beispielsweise kann die erste Schicht vier Deckelelektroden umfassen. Es ist aber auch eine andere Anzahl von Deckelelektroden in der ersten Schicht möglich.

Die Deckelelektroden sind vorzugsweise in einem Array angeordnet. Beispielsweise kann die erste Schicht ein Array von 2x2 oder 3x3 oder 4x4, usw., Deckelelektroden aufweisen. Es ist aber auch möglich, dass in einer ersten Richtung der ersten Schicht mehrere oder weniger Deckelelektroden angeordnet sind als in einer dazu orthogonalen zweiten Richtung. D.h. die erste Schicht kann z.B. ein Array von 3x2, 2x3, 3x5, 5x3, usw., Elektroden aufweisen. Insbesondere können die Deckelelektroden in einem Array derart angeordnet sein, dass das Array eine beliebige Struktur, wie z.B. eine Dreiecksstruktur oder eine Wabenstruktur, ergibt. Eine Deckelelektrode kann z.B. eine Abmessung bzw. eine Fläche von etwa 3 mm × 3 mm bis etwa 50 mm × 50 mm aufweisen. Die Dicke einer Deckelelektrode kann z.B. zwischen etwa 1 µm und 1 mm liegen. Es versteht sich, dass je nach Anwendung, auch andere Werte möglich sind.

Die zweite Schicht ist elektrisch isolierend und verformbar. Vorzugsweise ist die zweite Schicht rückstellbar verformbar bzw. elastisch. Insbesondere ist die zweite Schicht aus einem Schaumstoff gebildet. Die zweite Schicht bzw. der Schaumstoff weist vorzugsweise eine Abmessung bzw. eine Fläche auf, die im Wesentlichen der Summe der Deckelelektrodenflächen entspricht. Die Dicke der zweiten Schicht bzw. des Schaustoffs kann z.B. etwa 0,2 mm bis 3 mm betragen. Es versteht sich, dass je nach Anwendung, auch andere Werte möglich sind.

Die dritte Schicht umfasst eine Bodenelektrode. Insbesondere ist die dritte Schicht eine Bodenelektrode. Die Fläche der Bodenelektrode entspricht vorzugsweise im Wesentlichen der Fläche der zweiten Schicht, d.h. der Summe der Deckelelektrodenflächen.

Die Bodenelektrode weist vorzugsweise eine Dicke im Bereich von etwa 1 µm bis 1 mm auf. Es versteht sich, dass je nach Anwendung, auch andere Werte möglich sind.

Gemäß den Begriffen "Deckelelektrode" und "Bodenelektrode" ist die erste Schicht bzw. sind die Deckelelektroden oberhalb der dritten Schicht bzw. der Bodenelektrode angeordnet. Insbesondere ist unmittelbar unterhalb der ersten Schicht die zweite Schicht angeordnet und ist unmittelbar unterhalb der zweiten Schicht die dritte Schicht angeordnet.

Unter dem Begriff "Deckelelektrode" wird verstanden, dass in dem Sensormodul oberhalb der Deckelelektroden, d.h. zu der von der zweiten Schicht abgewandten Seite der ersten Schicht, keine weitere elektrisch leitfähige Schicht mehr angeordnet ist. Entsprechend wird unter dem Begriff "Bodenelektrode" verstanden, dass in dem Sensormodul unterhalb der Bodenelektrode, d.h. zu der von der zweiten Schicht abgewandten Seite der dritten Schicht, keine weitere elektrisch leitfähige Schicht mehr angeordnet ist. Somit sind die erste und dritte Schicht die einzigen elektrisch leitfähigen Schichten des Sensorelements.

Dies schließt aber nicht aus, dass sich oberhalb der ersten Schicht und unterhalb der dritten Schicht noch weitere Isolationsschichten befinden. Vorzugsweise weist das Sensorelement oberhalb der ersten Schicht eine weitere, elektrisch isolierende, Schicht bzw. Isolationsschicht auf. Weiter vorzugsweise weist das Sensorelement unterhalb der dritten Schicht bzw. der Bodenelektrode eine weitere, elektrisch isolierende, Schicht bzw. Isolationsschicht auf. Diese weiteren Isolationsschichten können vorteilhafterweise ungewollte Kurzschlüsse vermeiden.

Das Sensorelement ist ausgelegt, in drei verschiedenen Mess-Konfigurationen bzw. in drei verschiedenen Betriebsmodi betrieben zu werden. In der selbst-kapazitiven Annäherungskonfiguration bzw. in dem selbst-kapazitiven Annäherungsmodus und in der beidseitig-kapazitiven Annäherungskonfiguration bzw. in dem beidseitig-kapazitiven Annäherungsmodus ist es vorteilhafterweise möglich, Annäherungs-Messwerte zu erfassen. In der beidseitig-kapazitiven Taktilitätskonfiguration bzw. in dem beidseitig-kapazitiven Taktilitätsmodus, im Folgenden auch einfach als taktile Konfiguration bzw. taktiler Modus bezeichnet, ist es vorteilhafterweise möglich, Taktilitäts-Messwerte zu erfassen.

Unter "Annäherungs-Messwerte" werden allgemein Messwerte verstanden, die geeignet sind, die Annäherung eines Objekts an das Sensormodul zu detektieren. Entsprechend werden unter "Taktilitäts-Messwerte" allgemein Messwerte verstanden, die geeignet sind, einen Kontakt bzw. eine Berührung eines Objekts mit dem Sensormodul, insbesondere kraftaufgelöst, zu detektieren. Beispielsweise können die Annäherungs-Messwerte und die Taktilitäts-Messwerte Messwerte umfassen, die eine Kapazität oder eine Kapazitätsänderung repräsentieren. Typischerweise können Kapazitätsänderungen von etwa 1 pF bis 12 pF auftreten, wobei diese Werte von der Größe der Elektroden abhängig sind.

In der selbst-kapazitiven Annäherungskonfiguration wird ein Erregersignal bzw. eine Wechselspannung auf zumindest eine der Deckelelektroden, insbesondere auf eine oder mehrere ausgewählte Deckelelektroden, gelegt, aufgrund welcher ein elektrisches Feld um die zumindest eine Deckelelektrode herum aufgebaut wird. Dabei kann die Wechselspannung eine Sinus-Spannung, aber auch eine beliebig andere periodische Spannung, wie z.B. eine Dreiecksspannung, sein. Objekte oder weitere Sensormodule in der Umgebung beeinflussen das Feld, was den fließenden Strom ändert. Diese Stromänderung kann gemessen werden. Das Erregersignal bzw. die Wechselspannung kann z.B. eine Frequenz von 100 kHz und eine Peak-to-Peak Spannung von 5 V aufweisen. Es versteht sich, dass aber auch andere Werte gewählt werden können.

In der beidseitig-kapazitiven Annäherungskonfiguration wird von zumindest einer der Deckelelektroden, insbesondere von einer oder mehrerer ausgewählten Deckelelektroden, ein Strom empfangen, der von einer externen Quelle gesendet bzw. mittels einer externen Quelle induziert wird. Objekte beeinflussen auch hier das elektrische Feld, was über eine Strommessung feststellbar ist.

In der taktilen Konfiguration wird die Kapazität zwischen zumindest einer der Deckelelektroden, insbesondere einer oder mehrerer ausgewählter Deckelelektroden, und der Bodenelektrode gemessen. Wenn sich durch eine mechanische Belastung der Abstand zwischen der zumindest einen Deckelelektrode und der Bodenelektrode ändert, wirkt sich das wiederum als eine Änderung im Strom aus, welche gemessen - werden kann.

Dadurch, dass die erste Schicht des Sensorelements eine Vielzahl von Deckelelektroden umfasst, kann sowohl die Detektion einer Annäherung als auch die Detektion einer Taktilität vorteilhafterweise ortsaufgelöst erfolgen. Dabei fungieren die einzelnen Deckelelektroden als Pixelelemente des Sensors, d.h. die Ortsauflösung wird durch die Anzahl der Deckelelektroden pro Einheitsfläche bestimmt.

Weiter vorteilhafterweise weist das erfindungsgemäße Sensormodul bzw. das Sensorelement des Sensormoduls nur zwei leitfähige Schichten auf, so dass es kompakt und kostengünstig in der Herstellung ist.

In einer bevorzugten Ausführungsform weist das Sensormodul einen Mehrfachschalter auf. Durch diesen Mehrfachschalter ist jede einzelne Deckelelektrode, welche im Sinne der vorliegenden Erfindung auch als Pixelelemente angesehen werden können, ansteuerbar. Alternativ oder zusätzlich können mit Hilfe des Mehrfachschalters zwei oder mehrere, insbesondere vorbestimmte bzw. ausgewählte, Deckelelektroden zusammengefasst bzw. elektrisch miteinander verbunden werden. Vorzugsweise kann zumindest eine Deckelelektrode mit einer Messeinheit und/oder mit einer Erregersignalerzeugungseinheit bzw. Wechselspannungsquelle verbunden werden. Insbesondere kann zumindest eine Deckelelektrode mit Hilfe des Mehrfachschalters aus der Vielzahl von Deckelelektroden ausgewählt werden und daher auch als die zumindest eine ausgewählte Deckelelektrode bezeichnet werden. Ferner kann der Mehrfachschalter ausgelegt sein, ein oder mehrere, insbesondere zwei oder mehrere, z.B. drei, vier, fünf, usw., der Vielzahl von Deckelelektroden zu einem Deckelelektroden-Cluster, d.h. zu einem größeren Pixelelement, zusammenzuschalten, um sie gemeinsam für eine kapazitive Messung zu nutzen. Das resultierende Cluster bzw. das resultierende Pixelelement kann nach Durchführung eines Messzyklus verschoben und die Messung anschließend wiederholt werden. Auf diese Weise kann eine Pseudo-Ortsauflösung erreicht werden. Insbesondere kann durch das Zusammenschalten mehrerer Deckelelektroden zu einem Cluster und durch das Verschieben des Clusters vorteilhafterweise eine höhere Reichweite bei gleich bleibender Ortsauflösung erreicht werden.

Das Sensormodul umfasst eine Messeinheit, welche ausgelegt ist, das Sensorelement in den drei verschiedenen Mess-Konfigurationen zu betreiben.

Die Messeinheit umfasst vorzugsweise eine Kapazitätsmessschaltung, d.h. eine Schaltung, mit der eine Kapazität und/oder eine Änderung der Kapazität messbar sind. Weiter vorzugsweise weist die Messeinheit zumindest einen Betriebsmodus- bzw. Konfigurationsschalter auf, mit dem die verschiedenen Konfigurationen bzw. Betriebsmodi des Sensorelements eingestellt bzw. aktiviert werden können, d.h. mit dem zwischen den verschiedenen Konfigurationen bzw. Betriebsmodi des Sensorelements gewechselt werden kann.

In einer weiteren bevorzugten Ausführungsform ist die Messeinheit ausgelegt, Annäherungs-Messdaten in der selbst-kapazitiven Annäherungskonfiguration und in der beidseitig-kapazitiven Annäherungskonfiguration zu erfassen. Ferner ist die Messeinheit ausgelegt, Taktilitäts-Messdaten in der taktilen Konfiguration zu erfassen. Die Erfassung von Annäherungs-Messdaten und Taktilitäts-Messdaten erfolgt vorzugsweise mit Hilfe eines Mess-Schaltkreises, welcher z.B. Teil der Messeinheit sein kann und welcher vorzugsweise ausgelegt ist, zwischen der selbst-kapazitiven Annäherungskonfiguration, der beidseitig-kapazitiven Annäherungskonfiguration und der taktilen Konfiguration umzuschalten.

Die Messeinheit ist ausgelegt, in der selbst-kapazitiven Annäherungskonfiguration zumindest eine der Deckelelektroden, insbesondere die zumindest eine ausgewählte Deckelelektrode bzw. das Deckelelektroden-Cluster, in einem Sendemodus zu betreiben. Mit anderen Worten ist die Messeinheit vorzugsweise ausgelegt, in der selbst-kapazitiven Annäherungskonfiguration zumindest eine der Deckelelektroden, insbesondere die zumindest eine ausgewählte Deckelelektrode bzw. das Deckelelektroden-Cluster, als Sendeelektrode(n) zu betreiben.

Unter einem "Sendemodus" wird im Sinne dieser Erfindung verstanden, dass an die zumindest eine ausgewählte Deckelelektrode bzw. das Deckelelektroden-Cluster ein Erregersignal, insbesondere eine Wechselspannung, angelegt wird. Mit anderen Worten ist im Sendemodus an die zumindest eine ausgewählte Deckelelektrode bzw. das Deckelelektroden-Cluster ein Erregersignal, insbesondere eine Wechselspannung, angelegt bzw. ist die zumindest eine ausgewählte Deckelelektrode mit einem Erregersignal beaufschlagt.

Insbesondere ist die Messeinheit ausgelegt, in der selbst-kapazitiven Annäherungskonfiguration die zumindest eine Deckelelektrode bzw. das Deckelelektroden-Cluster mit einem Erregersignal bzw. einer Wechselspannung zu beaufschlagen und den dadurch resultierenden Strom zu messen.

Ferner ist die Messeinheit ausgelegt, in der beidseitig-kapazitiven Annäherungskonfiguration zumindest eine der Deckelelektroden, insbesondere die zumindest eine ausgewählte Deckelelektrode bzw. das Deckelelektroden-Cluster, im Sendemodus oder in einem Empfangsmodus zu betreiben. Mit anderen Worten ist die Messeinheit vorzugsweise ausgelegt, in der beidseitig-kapazitiven Annäherungskonfiguration zumindest eine der Deckelelektroden, insbesondere die zumindest eine ausgewählte Deckelelektrode bzw. das Deckelelektroden-Cluster, als Sendeelektrode oder als Empfangselektrode zu betreiben.

Unter einem "Empfangsmodus" wird im Sinne dieser Erfindung verstanden, dass von der zumindest einen ausgewählten Deckelelektrode bzw. dem Deckelelektroden-Cluster ein Strom aufgrund einer externen Erregerquelle empfangen und gemessen wird. Insbesondere wird in der zumindest einen ausgewählten Deckelelektrode aufgrund eines externen Erregersignals ein Strom induziert, welcher gemessen werden kann bzw. gemessen wird.

Insbesondere ist die Messeinheit ausgelegt, in der beidseitig-kapazitiven Annäherungskonfiguration einen, in der zumindest einen Deckelelektrode bzw. dem Deckelelektroden-Cluster empfangenen bzw. induzierten, Strom zu messen ohne eine Wechselspannung an die zumindest eine Deckelelektrode bzw. das Deckelelektroden-Cluster anzulegen.

Ferner ist die Messeinheit ausgelegt, in der taktilen Konfiguration zumindest eine der Deckelelektroden, insbesondere die zumindest eine ausgewählte Deckelelektrode bzw. das Deckelelektroden-Cluster, im Sendemodus und die Bodenelektrode im Empfangsmodus zu betreiben. Mit anderen Worten ist die Messeinheit ausgelegt, in der taktilen Konfiguration zumindest eine der Deckelelektroden, insbesondere die zumindest eine ausgewählte Deckelelektrode bzw. das Deckelelektroden-Cluster, als Sendeelektrode und die Bodenelektrode als Empfangselektrode zu betreiben.

In einer weiteren bevorzugten Ausführungsform weist die Messeinheit eine Erregersignalerzeugungseinheit bzw. Wechselspannungsquelle und eine Kapazitätsmesseinrichtung auf. Zudem ist in der selbst-kapazitiven Annäherungskonfiguration zumindest eine der Deckelelektroden, insbesondere die zumindest eine ausgewählte Deckelelektrode bzw. das Deckelelektroden-Cluster, sowohl mit der Erregersignalerzeugungseinheit als auch mit der Kapazitätsmesseinrichtung verbunden. Ferner ist in der beidseitig-kapazitiven Annäherungskonfiguration die zumindest eine Deckelelektrode mit der Kapazitätsmesseinrichtung verbunden. Ferner ist in der taktilen Konfiguration die zumindest eine Deckelelektrode mit der Erregersignalerzeugungseinheit verbunden und die Bodenelektrode mit der Kapazitätsmesseinrichtung verbunden.

In einer weiteren bevorzugten Ausführungsform weist die Messeinheit eine Messbrücke zur Erfassung der Annäherungs-Messdaten auf. Alternativ oder zusätzlich weist die Messeinheit einen Messwiderstand zur Erfassung der Taktilitäts-Messdaten auf. Alternativ oder zusätzlich weist die Messeinheit einen Spannungsfolger auf, wobei der Spannungsfolger in der selbst-kapazitiven Annäherungskonfiguration und/oder in der beidseitig-kapazitiven Annäherungskonfiguration mit der Bodenelektrode verbunden ist. Insbesondere ist in der selbst-kapazitiven Annäherungskonfiguration und/oder in der beidseitig-kapazitiven Annäherungskonfiguration ein Eingang des Spannungsfolgers mit der Erregersignalerzeugungseinheit verbunden, während ein Ausgang des Spannungsfolgers mit der Bodenelektrode verbunden ist. Mit anderen Worten wird die Wechselspannung nicht nur an die zumindest eine Deckelelektrode, sondern auch an die Bodenelektrode angelegt, wodurch die Bodenelektrode vorteilhafterweise eine Schirmwirkung entfaltet, um Einflüsse von der Rückseite des Sensorelements zu reduzieren oder zu verhindern.

In einer weiteren bevorzugten Ausführungsform weist die Messeinheit eine Messbrücke zur Erfassung der Annäherungs-Messdaten auf. Ferner weist die Messeinheit vorzugsweise einen ersten Schalter auf, mit dem die Messbrücke entweder mit einer Erregersignalerzeugungseinheit bzw. Wechselspannungsquelle oder mit Masse verbunden werden kann. Dieser erste Schalter dient zum Umschalten zwischen Sende-Modus und Empfangs-Modus. Somit ist das Sensormodul vorteilhafterweise flexibel und vielseitig einsetzbar.

In einer weiteren bevorzugten Ausführungsform weist die Messeinheit einen Messwiderstand zur Erfassung der Taktilitäts-Messdaten und einen Spannungsfolger zum Abschirmen der Bodenelektrode auf. Ferner weist die Messeinheit einen zweiten Schalter auf, mit dem die Bodenelektrode entweder mit dem Messwiderstand oder mit dem Spannungsfolger verbunden werden kann. Dieser zweite Schalter dient zum Umschalten zwischen einer Näherungsmessung und einer taktilen Messung. Somit ist das Sensormodul vorteilhafterweise flexibel und vielseitig einsetzbar.

Ein weiterer unabhängiger Aspekt zur Lösung der Aufgabe betrifft ein Sensorsystem zum kapazitiven und ortsaufgelösten Detektieren der Annäherung eines Objektes an das Sensormodul und zum kapazitiven und ortsaufgelösten Erfassen von taktilen Ereignissen zwischen einem Objekt und dem Sensormodul, wobei das Sensorsystem eine Vielzahl von erfindungsgemäßen Sensormodulen umfasst.

In einer bevorzugten Ausführungsform des erfindungsgemäßen Sensorsystems sind die Sensormodule zu einem Array angeordnet. Vorzugsweise sind die Messeinheiten der Sensormodule ausgelegt, jeweils zwei aneinandergrenzende bzw. benachbarte Cluster von Deckelelektroden der Vielzahl von Sensormodulen zusammenzuschalten.

Vorzugsweise erfolgt das Zusammenschalten der Deckelelektroden mit Hilfe eines oder mehrerer Mehrfachschalter der Steuereinheiten der Sensormodule. Insbesondere erfolgt das Zusammenschalten von benachbarten Deckelelektroden, die jeweils zwei unterschiedlichen Sensormodulen angehören, durch den Mehrfachschalter eines der zwei unterschiedlichen Sensormodule. Mit anderen Worten ist ein Mehrfachschalter eines Sensormoduls nicht nur mit den Deckelelektroden des eigenen Sensormoduls verbunden bzw. verbindbar, sondern auch mit benachbarten Deckelelektroden eines anderen, insbesondere benachbarten, Sensormoduls.

Ein weiterer unabhängiger Aspekt zur Lösung der Aufgabe betrifft ein Verfahren zum kapazitiven und ortsaufgelösten Detektieren der Annäherung eines Objekts und zum kapazitiven und ortsaufgelösten Erfassen von taktilen Ereignissen, umfassend die Schritte:
- Bereitstellen eines oder mehrerer erfindungsgemäßer Sensormodule oder Bereitstellen eines erfindungsgemäßen Sensorsystems;
- Betreiben der Sensormodule bzw. Sensorelemente in der selbst-kapazitiven Annäherungskonfiguration oder der beidseitig-kapazitiven Annäherungskonfiguration und Erfassen von Annäherungs-Messdaten, insbesondere der Annäherungs-Messdaten für jedes Sensormodul, und/oder
- Betreiben der Sensormodule bzw. Sensorelemente in der taktilen Konfiguration und Erfassen von Taktilitäts-Messdaten, insbesondere der Taktilitäts-Messdaten für jedes Sensormodul.

In einer bevorzugten Ausführungsform des Verfahrens werden die Sensormodule bzw. Sensorelemente abwechselnd in der selbst-kapazitiven Annäherungskonfiguration, in der beidseitig-kapazitiven Annäherungskonfiguration und in der taktilen Konfiguration betrieben. Die Frequenz für das Wechseln der verschiedenen Konfigurationen liegt vorzugsweise in einem Bereich von etwa 100 Hz bis 500 Hz. Somit ist es vorteilhafterweise möglich, eine mögliche Annäherung und ein mögliches taktiles Ereignis quasi simultan zu überwachen bzw. eine Annäherung und ein taktiles Ereignis quasi simultan zu detektieren.

Ein weiterer unabhängiger Aspekt zur Lösung der Aufgabe betrifft eine Verwendung des erfindungsgemäßen Sensormoduls oder des erfindungsgemäßen Sensorsystems als taktiler Näherungssensor in funktionalen Oberflächen und/oder zur Ausbildung einer Sensorhaut in der Robotik.

Insbesondere kann das erfindungsgemäße Sensormodul oder das erfindungsgemäße Sensorsystem als taktiler Näherungssensor in Gegenständen der Unterhaltungs- und Consumer-Elektronik, wie z.B. in Smartphones, Tablets, Videospielkonsolen, Musikinstrumente, etc., verwendet werden. Das erfindungsgemäße Sensormodul oder das erfindungsgemäße Sensorsystem kann aber auch als taktiler Näherungssensor in Gegenständen der Medizintechnik, z.B. für die berührungslose Interaktion zur Vermeidung von Kontamination, etc., und/oder in industriellen Gegenständen, z.B. zur Ausbildung eines Näherungsschalters, etc., verwendet werden. Funktionale Oberflächen können auch in aktiven Wänden, aktiven Böden, aktiver Kleidung, aktiver Möbel, etc., enthalten sein, so dass das erfindungsgemäße Sensormodul oder das erfindungsgemäße Sensorsystem auch in solchen Gegenständen als taktiler Näherungssensor verwendet werden kann.

In der Robotik kann das erfindungsgemäße Sensormodul oder das erfindungsgemäße Sensorsystem z.B. in Greifern oder an Armsegmenten einer Maschine bzw. Roboters, insbesondere zur sicheren Mensch-Maschine Kooperation, verwendet werden.

Für die oben genannten weiteren unabhängigen Aspekte und insbesondere für diesbezügliche bevorzugte Ausführungsformen gelten auch die vor- oder nachstehend gemachten Ausführungen zu den Ausführungsformen des ersten Aspekts. Insbesondere gelten für einen unabhängigen Aspekt der vorliegenden Erfindung und für diesbezügliche bevorzugte Ausführungsformen auch die vor- und nachstehend gemachten Ausführungen zu den Ausführungsformen der jeweils anderen Aspekte.

Im Folgenden werden einzelne Ausführungsformen zur Lösung der Aufgabe anhand der Figuren beispielhaft beschrieben. Dabei weisen die einzelnen beschriebenen Ausführungsformen zum Teil Merkmale auf, die nicht zwingend erforderlich sind, um den beanspruchten Gegenstand auszuführen, die aber in bestimmten Anwendungsfällen gewünschte Eigenschaften bereitstellen. So sollen auch Ausführungsformen als unter die beschriebene technische Lehre fallend offenbart angesehen werden, die nicht alle Merkmale der im Folgenden beschriebenen Ausführungsformen aufweisen. Ferner werden, um unnötige Wiederholungen zu vermeiden, bestimmte Merkmale nur in Bezug auf einzelne der im Folgenden beschriebenen Ausführungsformen erwähnt. Es wird darauf hingewiesen, dass die einzelnen Ausführungsformen daher nicht nur für sich genommen, sondern auch in einer Zusammenschau betrachtet werden sollen. Anhand dieser Zusammenschau wird der Fachmann erkennen, dass einzelne Ausführungsformen auch durch Einbeziehung von einzelnen oder mehreren Merkmalen anderer Ausführungsformen modifiziert werden können. Es wird darauf hingewiesen, dass eine systematische Kombination der einzelnen Ausführungsformen mit einzelnen oder mehreren Merkmalen, die in Bezug auf andere Ausführungsformen beschrieben werden, wünschenswert und sinnvoll sein kann und daher in Erwägung gezogen und auch als von der Beschreibung umfasst angesehen werden soll.

### Kurze Beschreibung der Zeichnungen

- Figur 1a: zeigt eine schematische Prinzip-Skizze eines selbst-kapazitiven Systems mit einem geerdeten Objekt;
- Figur 1b: zeigt eine schematische Prinzip-Skizze eines selbst-kapazitiven Systems mit einem nicht geerdeten Objekt;
- Figur 2: zeigt eine schematische Prinzip-Skizze eines beidseitigkapazitiven Systems;
- Figur 3a: zeigt eine schematische Prinzip-Skizze der elektrostatischen Kopplung zweier Objekte ohne Schirm;
- Figur 3b: zeigt eine schematische Prinzip-Skizze der elektrostatischen Kopplung zweier Objekte mit Schirm;
- Figur 4a: zeigt eine schematische Skizze des Aufbaus eines Sensorelements gemäß einer bevorzugten Ausführungsform der vorliegenden Erfindung;
- Figur 4b: zeigt eine schematische Skizze eines Sensorelements mit vier Deckelelektroden gemäß einer beispielhaften Ausführungsform;
- Figur 4c: zeigt eine schematische Skizze eines Mehrfachschalters zur Ansteuerung der vier Deckelelektroden aus Figur 4b;
- Figur 5: zeigt eine schematische Skizze des Aufbaus eines Sensorelements gemäß einer weiteren bevorzugten Ausführungsform der vorliegenden Erfindung;
- Figur 6: zeigt eine schematische Skizze eines Sensormoduls in einer selbst-kapazitiven Annäherungskonfiguration gemäß einer bevorzugten Ausführungsform der vorliegenden Erfindung;
- Figur 7: zeigt eine schematische Skizze eines Sensormoduls in einer beidseitig-kapazitiven Annäherungskonfiguration als Empfänger gemäß einer bevorzugten Ausführungsform der vorliegenden Erfindung;
- Figur 8: zeigt eine schematische Skizze eines Sensormoduls in einer beidseitig-kapazitiven Taktilitätskonfiguration gemäß einer bevorzugten Ausführungsform der vorliegenden Erfindung;
- Figur 9: zeigt ein schematisches Systemdiagramm eines Sensormoduls gemäß einer bevorzugten Ausführungsform der vorliegenden Erfindung;
- Figur 10: zeigt eine schematische Skizze einer Mess- bzw. Auswerteeinheit eines Sensormoduls gemäß einer bevorzugten Ausführungsform;
- Figur 11a: zeigt eine schematische Skizze eines Sensormoduls gemäß einer beispielhaften Ausführungsform der vorliegenden Erfindung in einer perspektivischen Vorderansicht;
- Figur 11b: zeigt eine schematische Skizze eines Sensormoduls gemäß einer beispielhaften Ausführungsform der vorliegenden Erfindung in einer perspektivischen Rückansicht;
- Figur 12a-12c: zeigen schematische Skizzen zu einem intelligenten Zusammenfassen und Abtasten einzelner Deckelelektroden einem vernetzten, mehrere Sensorelemente umfassenden Sensorsystem;
- Figur 13: zeigt zwei anliegende Sensorelemente in einer ersten beispielhaften Messkonfiguration;
- Figur 14: zeigt zwei anliegende Sensorelemente in einer zweiten beispielhaften Messkonfiguration;
- Figur 15: zeigt eine schematische Skizze zur Verwendung der erfindungsgemäßen Sensormodule am Beispiel einer Sensorhaut für einen Roboter.

### Detaillierte Beschreibung der Zeichnungen

Die in der vorliegenden Beschreibung gewählten Lageangaben, wie z. B. oben, unten, seitlich usw. sind jeweils auf die unmittelbar beschriebene sowie dargestellte Figur bezogen und sind bei einer Lageänderung sinngemäß auf die neue Lage zu übertragen.

Die vorliegende Erfindung macht sich ein Phänomen elektrischer Felder zu Nutze. Diese Felder werden über Schaltungen mit Hilfe von Elektroden systematisch erzeugt und gemessen. Durch geeignete Wahl der Anordnung der Elektroden können sowohl eine Annährung als auch eine Taktilität erfasst werden. Hierbei wird ausgenutzt, dass sich über Wechselströme kapazitive Veränderungen in diesen Anordnungen messen lassen.

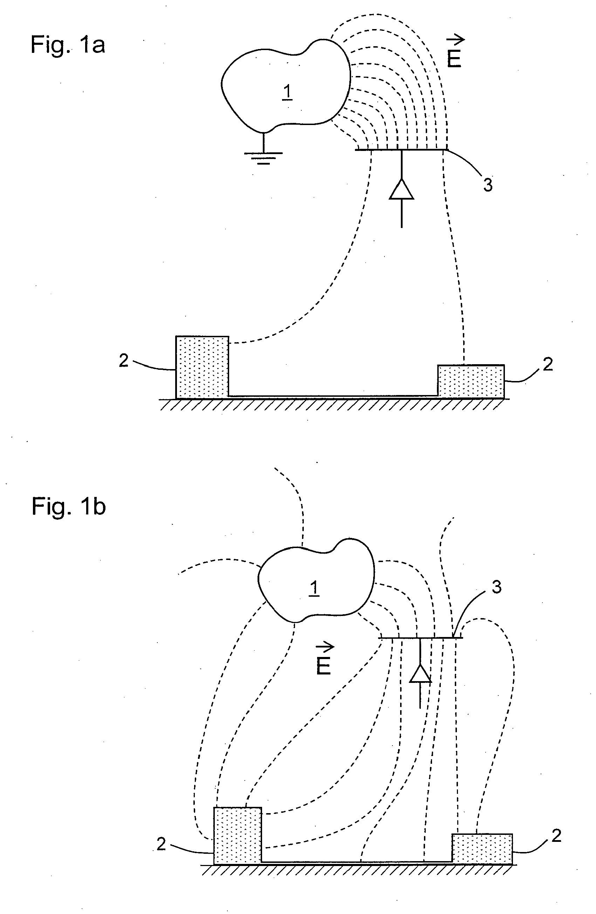

Im Folgenden werden zunächst anhand der **Figuren 1a bis 3b** verschiedene kapazitive Systeme zum besseren Verständnis der vorliegenden Erfindung allgemein beschrieben. Dabei sind in den unterschiedlichen Systemen jeweils die elektrischen Feldlinien durch gestrichelte Linien eingezeichnet und mit jeweils E gekennzeichnet.

Prinzipiell entsteht eine kapazitive Kopplung zwischen zwei geladenen Leitern, die durch einen Nichtleiter bzw. ein Dielektrikum voneinander isoliert sind. Die Kapazität dieser Anordnung ist vom Abstand zwischen den Leitern, der Geometrie der Leiter und der Dielektrizitätskonstante des Nichtleiters abhängig.

Zur Detektion einer Annäherung kann der erfindungsgemäße Sensor bzw. das erfindungsgemäße Sensormodul in zwei unterschiedlichen Konfigurationen, nämlich in einer selbst-kapazitiven Konfiguration und einer beidseitig-kapazitiven Konfiguration, betrieben werden.

Bei einem selbst-kapazitiven System, welches in den **Figuren 1a und 1b** schematisch dargestellt ist, stellt eine Messelektrode 3 des Sensors die erste Kondensatorelektrode und ein Objekt 1 die zweite Kondensatorelektrode eines kapazitiven Systems dar.

Zunächst wird, wie in der **Figur** 1a dargestellt, davon ausgegangen, dass das Objekt 1 leitend ist und an Masse bzw. Erde angeschlossen ist. Sinkt der Abstand zwischen der Messelektrode 3 und dem Objekt 1, so steigt die Kapazität dieser Anordnung. Zur Objektdetektion anhand des selbst-kapazitiven Systems wird die Elektrode 3 mit einer Wechselspannung gespeist. Ist das Objekt 1 leitend und geerdet, koppelt die Elektrode 3 hauptsächlich an das Objekt 1. Die kapazitive Kopplung an die Umgebung bzw. Gegenständen 2 der Umgebung ist in diesem Fall vernachlässigbar.

Wenn das Objekt nicht geerdet ist, wie in der **Figur 1b** dargestellt, koppelt sich die Elektrode 3 kapazitiv sowohl an das Objekt 1 als auch an Gegenständen 2 der Umgebung. Bei einem nicht geerdeten Objekt 1 verursacht die Verschiebung des Objektes 1 zwar eine Kapazitätsänderung, diese ist aber sehr stark von den in der Umgebung liegenden geerdeten Gegenständen 2 beeinflusst.

Für den Fall, dass das Objekt 1 nichtleitend ist, oder leitend aber nicht geerdet ist, ist eine Messung der Kapazität bei variierender Umgebung nicht reproduzierbar, da die entstehende kapazitive Anordnung stark von dieser Umgebung abhängt. Wenn allerdings dieselben Randbedingungen während mehreren Messvorgängen herrschen, ist die Messung der Kapazität an sich reproduzierbar.

Ist das Objekt 1 nichtleitend, stellt es in der Reichweite des Sensors ein Dielektrikum zwischen der Messelektrode 3 und einem Gegenstand 2 in der Umgebung, insbesondere einem nicht definierten geerdeten Leiter, dar.

Ein leitendes Objekt 1 kann z.B. ein menschlicher Körper sein. Der menschliche Körper kann somit in diesem System als Kapazität dargestellt werden. Die gemessene Kapazität entsteht dann zwischen dem Körper des Menschen und der Sensorelektrode 3.

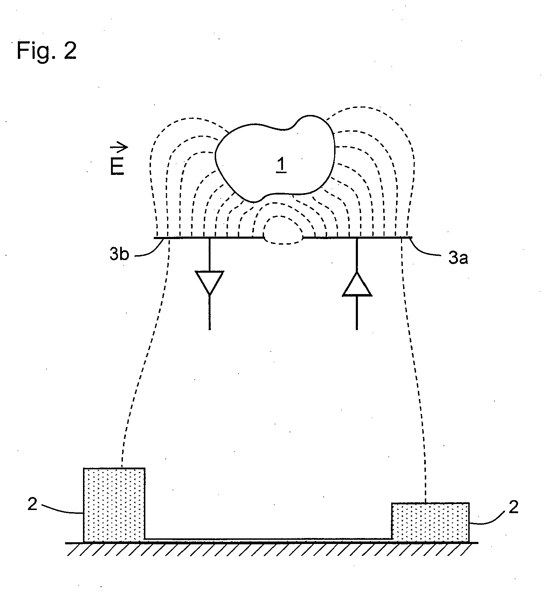

Ein beidseitig-kapazitives System, wie in der **Figur 2** schematisch dargestellt, eignet sich optimal zur Detektion von leitenden, aber nicht geerdeten bzw. von nichtleitenden Objekten.

Ein solches beidseitig-kapazitives System umfasst zwei Elektroden 3a und 3b. Die Elektrode 3a wird Sender und die Elektrode 3b wird Empfänger genannt, wobei der Abstand voneinander festgelegt ist. Diese Anordnung bildet einen Spezialfall eines Winkelkondensators mit dem Winkel α = 180°. Zur Objektdetektion wird die Elektrode 3a mit einer Wechselspannung gespeist, die dann von der Elektrode 3b empfangen und dort gemessen wird. Ein nicht leitendes Objekt 1 stellt in diesem System ein Dielektrikum dar. Damit hängt die entstehende Kapazität von der Geometrie und der Dielektrizitätskonstante des Objektes 1 und dessen Abstand zu den Elektroden 3a und 3b ab.

Befindet sich beispielsweise ein Objekt 1 im Feldraum der Anordnung in einem konstanten Abstand zu den Elektroden 3a und 3b, ist die Kapazität nur noch von der relativen Dielektrizitätskonstante abhängig. Je höher diese ist, desto höher ist die Kapazität, wodurch mehr Verschiebungsstrom zwischen der Elektrode 3a und der Elektrode 3b fließt.

Ist das Objekt 1 leitend, wirkt es wie ein Leiter zwischen den Elektroden 3a und 3b, wodurch sich der Kondensator in zwei in Reihe geschaltete Kondensatoren unterteilt. Hier steigt die Kapazität bei sinkendem Abstand zwischen dem Objekt 1 und den Elektroden 3a und 3b.

Im Falle eines leitenden geerdeten Objekts 1, verringert sich die Kapazität zwischen den Elektroden 3a und 3b bei sinkendem Abstand. Der Verschiebungsstrom wird größtenteils durch das Objekt 1 fließen, wodurch der gemessene Verschiebungsstrom in der Elektrode 3b kleiner wird. Mit anderen Worten wird in der Elektrode 3b weniger Strom empfangen. Das ist z.B. der Fall beim menschlichen Körper, vorausgesetzt dieser ist kapazitiv gut an Erde gekoppelt, was meistens angenommen werden kann.

Besitzen Objekte in einem Raum unterschiedliche elektrische Ladungsmengen bzw. Potentiale, so koppeln sie sich elektrostatisch aneinander. Das heißt, es entstehen zwischen den Objekten elektrische Feldlinien, die vom höheren Potential zum niedrigeren Potential gerichtet sind. Besitzen zwei Objekte dasselbe Potential, entstehen solche Feldlinien zwischen ihnen nicht mehr.

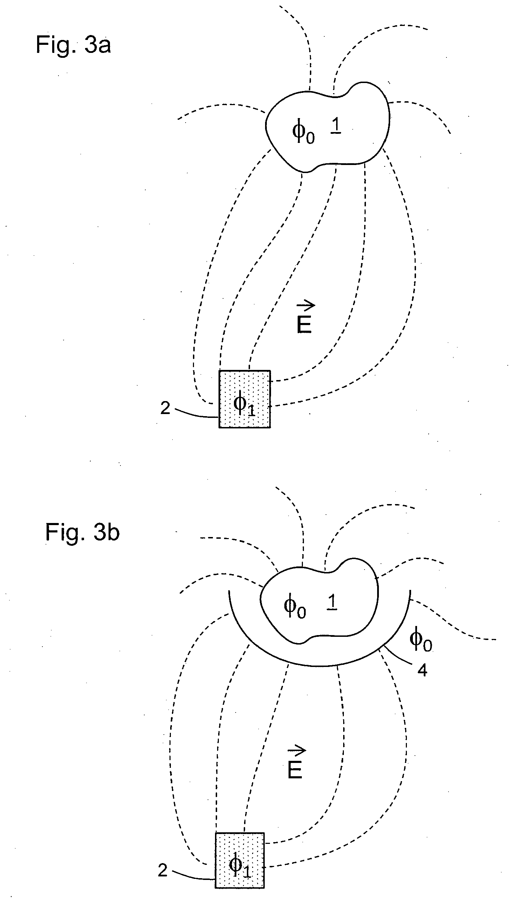

Wie in den **Figuren 3a und 3b** dargestellt, kann dieses Phänomen ausgenutzt werden, um elektrische Komponenten voneinander oder von der Umgebung abzuschirmen. Damit wird deren Abstrahlung oder eine Einstrahlung von außen verhindert oder zumindest verringert. In der Regel werden solche elektrische Komponenten von der Umgebung elektrostatisch isoliert, indem man sie mit leitfähigem Material, z.B. mit einer Metallfolie, das bzw. die niederohmig an Erde oder an ein Bezugspotential angeschlossen ist, umgibt. Im speziellen Fall wird die Abschirmfolie an dasselbe Potenzial der abzuschirmenden Komponenten angeschlossen, beispielsweise über einen Spannungsfolger.

In den **Figuren 3a und 3b** wird diese Schirmwirkung veranschaulicht. Hier ist das Objekt 1 mit einer leitende Platte 4, welche dasselbe Potential Φ₀ wie das Objekt 1 aufweist, abgeschirmt. Zu sehen ist, dass das Objekt an der Seite der Schirmplatte 4 von der Umgebung kapazitiv entkoppelt ist. Die Richtungen der Feldlinien sind hier nicht festgelegt und gelten für Φ₀ < Φ₁ bzw. Φ₀ > Φ₁. Diese Methode kann verwendet werden, um die Messelektrode des Sensors vom Rest der Elektronik abzuschirmen.

Eine Kapazität bzw. eine Kapazitätsänderung eines Kondensators kann insbesondere durch einen Lade- bzw. Entladevorgang des Kondensators, mittels einer Tiefpass-Schaltung und/oder mittels einer Messbrücke durch eine Vergleichsmessung gemessen werden.

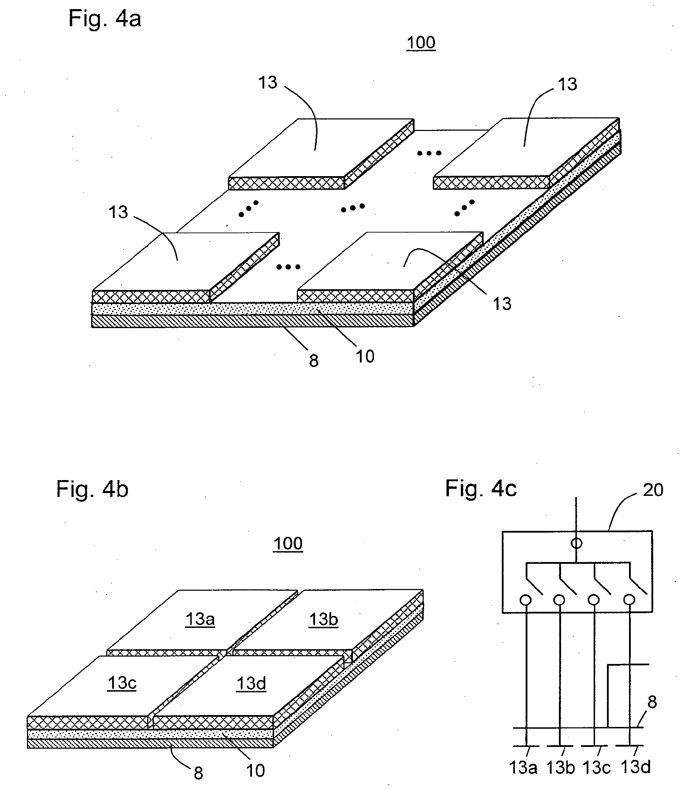

Anhand der **Figuren 4a bis 5** werden nun der Aufbau und die prinzipielle Funktionsweise eines erfindungsgemäßen Sensormoduls bzw. Sensorelements beschrieben.

Die **Figur 4a** zeigt eine schematische Skizze des Aufbaus des erfindungsgemäßen Sensormoduls bzw. Sensorelements 100. Das Sensorelement 100 weist eine erste, zweite und dritte Schicht auf. Nur insgesamt zwei Schichten des Sensorelements 100, nämlich die erste und die dritte Schicht, sind dabei leitfähige Schichten. Die erste Schicht weist eine Vielzahl von elektrisch leitfähigen Deckelelektroden 13 auf. Diese erste Schicht besteht insbesondere aus einem Array von n × m Deckelelektroden 13, d.h. aus einer Vielzahl von Deckelelektroden DE_{i,j} mit i = 1...n und j = 1 ...m. Die dritte Schicht weist eine elektrisch leitfähige Bodenelektrode 8 auf bzw. ist eine leitfähige Bodenelektrode 8. Je nach Modus bzw. Konfiguration übernimmt die Bodenelektrode unterschiedliche Funktionen. Die zweite Schicht 10, insbesondere eine Schaumstoffschicht, ist elektrisch isolierend und verformbar. Die zweite Schicht 10 ist unmittelbar zwischen der ersten und dritten Schicht, d.h. unmittelbar zwischen der Bodenelektrode 8 und den Deckelelektroden 13, angeordnet. Mit anderen Worten sind die beiden leitfähigen Schichten des Sensorelements 100 durch die isolierende Schaumstoffschicht 10 voneinander getrennt. Die zweite bzw. mittlere Schicht ist vorzugsweise ein elektrisch isolierender Schaumstoff, der als Feder im taktilen Modus dient.

Die **Figur 4b** zeigt eine schematische Skizze eines erfindungsgemäßen Sensorelements 100 mit vier Deckelelektroden 13a bis 13d. Die Bodenelektrode 8 ist pro Sensormodul bzw. Sensorelement 100 nur einzeln ausgeführt.

Über einen Mehrfachschalter 20, welcher in der **Figur 4c** skizziert ist, können die Deckelelektroden 13a bis 13d in beliebiger Weise zusammengeschaltet werden, um, elektrisch gesehen, eine größere Gesamtelektrode zu bilden. Ist A die zusammengefasste Fläche der Deckelelektroden 13a bis 13d, so können beispielsweise die Flächen 1/4A, 1/2A, 3/4 A oder A analog zusammengeschaltet werden.

Um eine Näherungsmessung durchzuführen, wird eine beliebige zusammengeschaltete Konfiguration der Deckelelektroden 13 mit einer Wechselspannung, deren Frequenz variabel gewählt werden kann, belegt. Gleichzeitig wird auf die Bodenelektrode 8 mit einem Spannungsverfolger die gleiche Spannung angelegt, um das Element nach hinten, d.h. zur Seite eines mechanischen Trägers des Sensorelements 100, abzuschirmen. In dieser selbst-kapazitiven Konfiguration werden die Sendeströme gemessen. Durch Zeitmultiplexen können quasi gleichzeitig, d.h. in einer für die Anwendung vernachlässigbaren Zeit, mehrere unterschiedliche Konfigurationen von zusammengeschalteten Deckelelektroden 13 abgefragt werden. Auf diese Weise kann in einem Zyklus eine große Gesamtfläche realisiert werden, während dennoch jede einzelne Deckelelektrode 13 abgefragt wird. Somit kann vorteilhafterweise eine hohe Reichweite und zugleich eine hohe Ortsauflösung erreicht werden.

Die taktile Messung erfolgt ebenfalls quasi simultan zur Näherungsmessung. Zur Erfassung von taktilen Ereignissen werden die Deckelelektroden 13 und die Bodenelektrode 8 in einem beidseitig-kapazitiven System betrieben. Im Falle einer mechanischen Belastung des Sensorelements 100, wird der Abstand von einer oder mehrerer der Deckelelektroden 13 zur Bodenelektrode 8 verkleinert. Der Schaumstoff der zweiten Schicht 10 wirkt hierbei als Feder, welche durch die Normalkraft gestaucht wird. Im beidseitig-kapazitiven System agieren die Deckelelektroden 13 jeweils einzeln oder zusammengeschaltet als Sendeelektrode und die Bodenelektrode 8 als Empfangselektrode, wobei der Strom auf der Empfängerseite gemessen wird. Eine dritte Messung, wieder der beidseitig-kapazitiven Art, wird möglich, wenn zwei oder mehrere Module bzw. Sensorelemente 100 teilnehmen. In einer Gruppe von Modulen wird eine Zusammenschaltung der Deckelelektroden 13 verwendet, um einen Strom zu generieren und zu senden, welcher durch eine Zusammenschaltung von Deckelelektroden 13 einer zweiten Gruppe von Modulen bzw. Sensorelementen 100 empfangen wird. Durch situatives Umkonfigurieren einer Mehrzahl von Modulen bzw. Sensorelementen 100 ist es so möglich, weitere Methoden, wie z.B. die kapazitive Tomographie, umzusetzen.

Das erfindungsgemäße Sensormodul 100 kann also mittels eines kapazitiven Messprinzips vorteilhafterweise sowohl Annäherungen und Kontakte detektieren. Dabei wird, wie bereits weiter oben erwähnt, unter der Erfassung von Annährung die Wahrnehmung von Ereignissen um den Sensor herum, insbesondere ab 0 mm bis z.B. etwa 100 mm, verstanden. Unter der Erfassung von Kontakten oder Taktilität wird das kraftauflösende Wahrnehmen von Berührungsereignissen, unabhängig von der Annährung, verstanden. Eine weitere vorteilhafte Eigenschaft des erfindungsgemäßen Sensors ist, dass er eine bestimmte, wählbare Ortsauflösung sowohl in der Annährung als auch bei der Taktilität besitzt. Dazu ist die obere Schicht des Sensorelements systematisch unterteilt, wobei die einzelnen Flächen bzw. Deckelelektroden 13 über einen Mehrfachschalter 20 in beliebiger Weise angesteuert und zusammengefasst werden können.

Für die prinzipielle Funktionalität des Sensors ist der in den **Figuren 4a und 4b** gezeigte drei-Schichten-Aufbau des Sensorelements 100 ausreichend. Um ungewollte Kurzschlüsse zu vermeiden, kann das Sensorelement 100 jedoch noch weitere nichtleitende Schichten aufweisen.

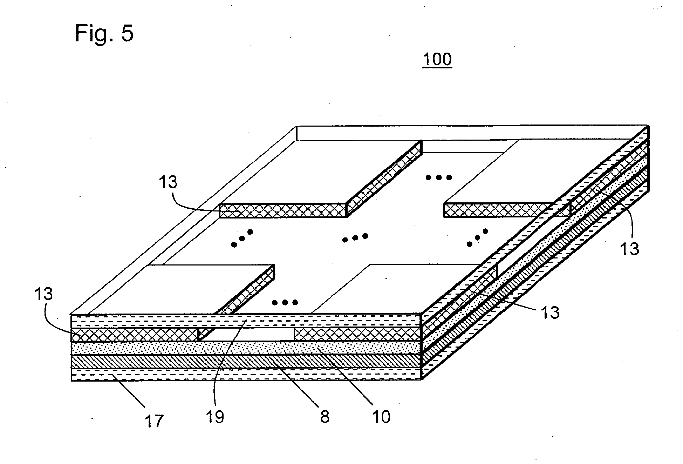

Wie in der **Figur 5** gezeigt, kann das Sensorelement 100 noch eine weitere elektrisch isolierende Schicht 19, die oberhalb der ersten Schicht, d.h. oberhalb der Deckelelektrodenschicht 13, angeordnet ist umfassen. Des Weiteren kann das Sensorelement 100 noch eine weitere elektrisch isolierende Schicht 17, die unterhalb der dritten Schicht, d.h. unterhalb der Bodenelektrode 8, angeordnet ist, umfassen. Die Isolationsschichten 17 und 19 können, je nach Anwendungsfall, als Montageschichten am Sensorelement 100 angebracht werden. Beispielsweise kann vor dem Anbringen des Sensorelements 100 an leitenden Oberflächen, wie z.B. einen Roboterarm, eine selbstklebende elektrische Isolationsschicht 17 unterhalb der Bodenelektrode 8 angebracht werden. Solche Isolationsschichten können den Kennlinienverlauf einer Messung beeinflussen, insbesondere verbessern. Sie sind aber für die prinzipielle Funktionalität des Sensormoduls bzw. Sensorelements 100 nicht notwendig.

Das erfindungsgemäße Sensormodul bzw. Sensorelement 100 kann in drei verschiedenen Mess-Konfigurationen bzw. Betriebsmodi betrieben werden. Zur Feststellung von Annährung wird das Sensorelement 100 entweder als selbstkapazitives System oder als beidseitig-kapazitives System betrieben und zur Erfassung von Kontakten im sogenannten taktilen Modus.

In dem selbst-kapazitiven System werden die Deckelelektroden 13 an ein Erregersignal angeschlossen, die Bodenelektrode 8 wird als Schirm verwendet. Die Deckelelektroden 13 bilden mit einem zu detektierenden Objekt einen Kondensator oder einen Teil eines Kondensators, dessen Kapazität vom Abstand zwischen dem Objekt und dem Sensor abhängig ist. Dieser Vorgang wird hier als Sende-Modus bezeichnet. Beim beidseitig-kapazitiven System werden zwei Sensormodule verwendet: Eines im Sende-Modus und das andere im Empfang-Modus. Im Empfang-Modus werden die Deckelelektroden 13 vom Erregersignal entkoppelt und über einen Analogmultiplexer an eine Messschaltung 30 angeschlossen, die den empfangenen Wechselstrom misst.

Im Taktil-Modus erfolgt die taktile Messung, indem man die Kapazität zwischen zumindest einer Deckelelektrode 13 und der Bodenelektrode 8 misst. Hierzu wird die zumindest eine Deckelelektrode 13 an die Erregerspannung angeschlossen und die Bodenelektrode 8 an die Messeinheit 30. Die zumindest eine Deckelelektrode 13 und die Bodenelektrode 8 sind über einen nichtleitenden Schaumstoff voneinander getrennt, der sich entsprechend des senkrechten Anteils einer auf dem Sensor ausübenden Druckkraft komprimiert. Die Komprimierung führt zu einer Abstandänderung zwischen der zumindest einen Deckelelektrode 13 und der Bodenelektrode 8 und somit zu einer messbaren Kapazitätsänderung.

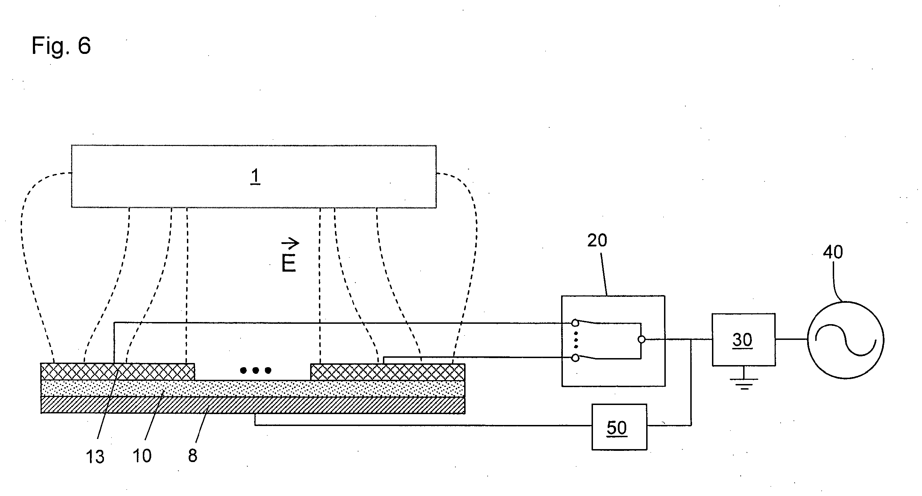

Anhand der **Figuren 6 bis 8** werden nachfolgend die einzelnen Betriebsmodi noch etwas genauer beschrieben.

Die **Figur 6** zeigt eine schematische Skizze des Sensormoduls bzw. Sensorelements 100 in einer selbst-kapazitiven Annäherungskonfiguration. Hierzu wird mittels einer Erregersignalerzeugungseinheit bzw. Wechselspannungsquelle 40 eine Wechselspannung auf mit dem Mehrfachschalter 20 ausgewählte bzw. angesteuerte Deckelelektroden 13 gelegt. Durch die Wechselspannung wird ein elektrisches Feld um die ausgewählten Deckelelektroden 13 herum aufgebaut. Objekte 1 oder weitere Sensormodule bzw. Sensorelemente in der Umgebung beeinflussen das elektrische Feld, was den fließenden Strom ändert. Dieser wird in einer Messschaltung bzw. einem Messkanal 30 gemessen. Die Bodenelektrode 8 dient in dieser selbst-kapazitiven Annäherungskonfiguration als Schirm, um Einflüsse von der Rückseite des Sensorelements 100 zu verhindern. Dazu wird das Potential der Bodenelektrode 8 mit Hilfe eines Spannungsfolgers 50, welcher einen Verstärkungsfaktor von 1 aufweist, an das Potential der mit dem Mehrfachschalter 20 ausgewählten Deckelelektroden 13 angeglichen.

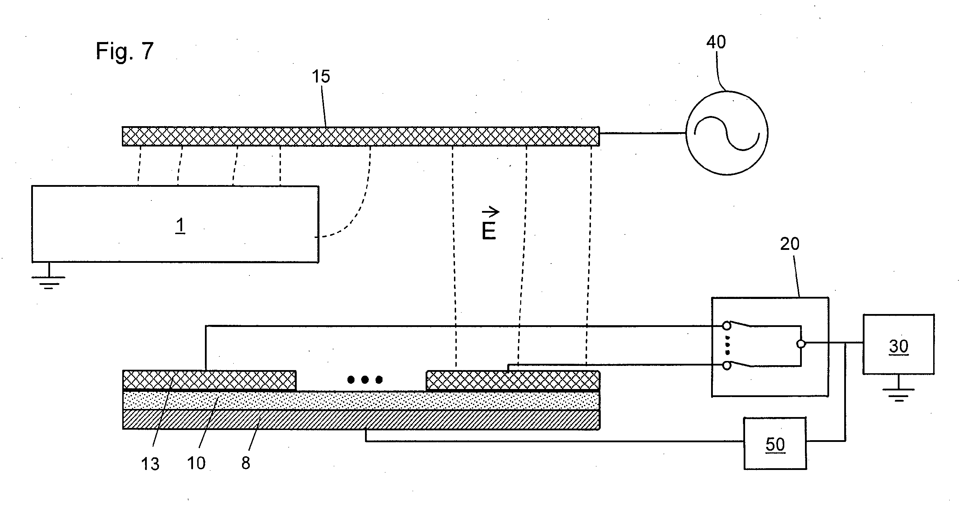

Die **Figur 7** zeigt eine schematische Skizze des Sensormoduls bzw. Sensorelements 100 in einer beidseitig-kapazitiven Annäherungskonfiguration als Empfänger. In dieser beidseitig-kapazitiven Annäherungskonfiguration wird ein Strom empfangen, der von einer externen Quelle 15 gesendet wird. Diese Quelle 15 kann z.B. ein weiteres Sensormodul im selbst-kapazitiven Betrieb sein. Objekte 1 beeinflussen auch hier das elektrische Feld, was über eine Strommessung mittels des Messkanals 30 feststellbar ist. Das Potential der Bodenelektrode 8 wird auch in der beidseitig-kapazitiven Annäherungskonfiguration mit Hilfe eines Spannungsfolgers 50 an das Potential der mit dem Mehrfachschalter 20 ausgewählten Deckelelektroden 13 angeglichen. Die Bodenelektrode 8 dient also auch in dieser Konfiguration als Schirm, um Einflüsse von der Rückseite des Sensorelements 100 zu verhindern.

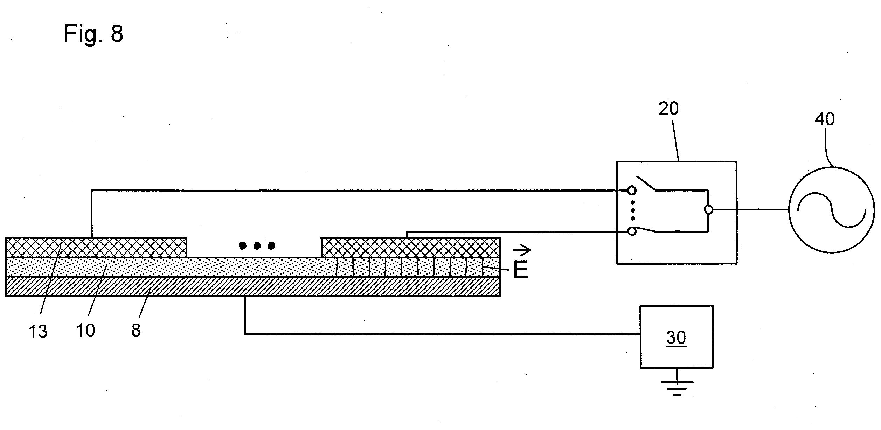

Die **Figur 8** zeigt eine schematische Skizze des Sensormoduls bzw. Sensorelements 100 in einer beidseitig-kapazitiven Taktilitätskonfiguration. Im Beispiel der **Figur 8** ist der Mehrfachschalter 20 derart konfiguriert, dass nur die rechte Deckelelektrode 13 mit einer Wechselspannung beaufschlagt ist. In diesem taktilen Modus wird die Kapazität zwischen der mit Wechselspannung beaufschlagten Deckelelektrode 13 und der Bodenelektrode 8 gemessen. Wenn sich durch eine mechanische Belastung der Abstand zwischen der mit Wechselspannung beaufschlagten Deckelelektrode 13 und der Bodenelektrode 8 ändert, d.h. wenn die Schaumstoffschicht 10 durch die mechanische Belastung zusammengedrückt wird, wirkt sich das wiederum als eine Änderung des mittels des Messkanals 30 gemessenen Stroms aus.

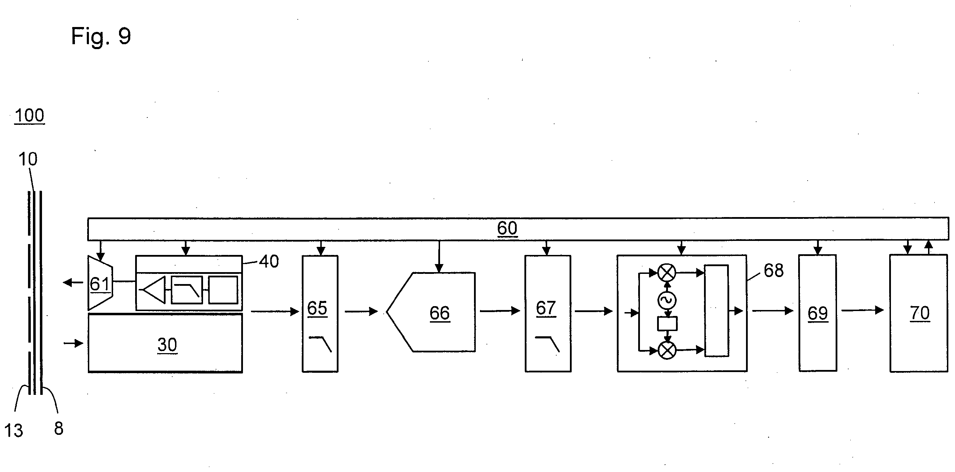

Die **Figur 9** zeigt in einem schematischen Diagramm das erfindungsgemäße Sensormodul in einer beispielhaften Ausführungsform. Insbesondere ist das erfindungsgemäße Sensorelement 100 zusammen mit einer Analog- und Digitalelektronik zum Betreiben des Sensorelements 100 dargestellt. In der gezeigten beispielhaften Ausführungsform umfasst das Sensormodul nicht nur das Sensorelement 100, sondern auch eine analoge Messschaltung bzw. eine Messeinheit 30 sowie eine digitale Steuer- und Signalverarbeitungseinheit. Die digitale Steuer- und Signalverarbeitungseinheit umfasst ein Kontrollregister 60, einen Multiplexer 61, eine Erregersignalerzeugungseinheit 40, einen Anti-Aliasing Filter 65, einen Analog-Digital-Wandler (ADC) 66, einen digitalen Filter 67, eine Amplitudenmodulationseinheit 68, eine Distanzberechnungseinheit 69, und ein Bus-System 70.

Die Digitalelektronik des Sensormoduls kann sowohl die Erzeugung des Erregersignals als auch die Datenverarbeitung umfassen. So können die Amplituden der analogen Signale digital ermittelt, bearbeitet und schließlich ausgegeben werden. Das Erregersignal, welches in der Erregersignalerzeugungseinheit 40 erzeugt wird, ist ein Sinussignal mit einstellbarer Frequenz und Phase. Das Erregersignal wird digital mit Verfahren der direkten digitalen Synthese, kurz DDS, erzeugt. Da das Signal digital synthetisiert wird, ist eine Tiefpassfilterung notwendig. Nach einem Tiefpassfilter wird das Signal verstärkt und auf die gewünschte Amplitude gebrächt.

Das Ausgangsignal der analogen Messschaltung wird nach einer Tiefpassfilterung, auch Antialiasing-Filterung genannt, mit dem Analog-Digital-Wandler 66 diskretisiert. Durch die Abtastung des Signals entstehen im Frequenzbereich spektrale Wiederholungen des Signalspektrums, die als störend betrachtet werden. Diese werden mit dem digitalen Filter 67 mit endlicher Impulsantwort, d.h. einem sogenannten "finite impulse response filter" (FIR) entfernt. Somit steht das digitalisierte Signal für weitere Signalverarbeitung bereit.

Das abgetastete Signal ist im idealen Fall ein Sinussignal bekannter Frequenz aber unbekannter Amplitude. Doch durch additives Rauschen und Überlagerung von Störsignalen kann das Signal verzerrt und dadurch die genaue Ermittlung der Amplitude erschwert werden. Zur Bestimmung der Amplitude wird ein Verfahren der digitalen Amplitudendemodulation mit Hilfe der Amplitudenmodulationseinheit 68 verwendet.

Das Sensormodul verfügt über ein Kontrollregister 60, mit dem ein Nutzer das Sensormodul konfigurieren kann. Der Nutzer ist in der Lage, verschiedene Parameter einzustellen, wie z.B. die Frequenz des Erregersignals, die Aktivierung einer Mittelwertbildung und die Art der Ergebnis- bzw. Sensorwertausgabe. Möglich ist es auch, über das Kontrollregister 60 bestimmte Messszenarien einzustellen, beispielsweise welcher Messmodus bei welcher Frequenz in welcher Reihenfolge erfolgen soll. Insbesondere ist das Kontrollregister 60 ein Speicherarray, das über eine Kommunikationsschnittstelle ausgelesen und beschrieben werden kann.

Bei bekannten Parametern für die Näherungskonfiguration, insbesondere bei bekannter Objektgröße, bekanntem Material und bekanntem Erdungszustand, kann optional mit Hilfe der Distanzberechnungseinheit 69 der Abstand des detektierten Objektes zum Sensor auf Basis der ermittelten Näherungsmessdaten über eine Regression errechnet werden. Die Sensorwerte werden dann über das Bus-System 70 an ein Host-System, beispielsweise eine vernetzte Haut oder ein PC, weitergegeben und über LEDs, welche am Sensorelement angebracht sind, farblich dargestellt.

Um die Sensordaten auszugeben bzw. darzustellen ist die Kommunikationsschnittstelle 70 vorgesehen, die der Ansteuerung des Sensormoduls und dem Auslesen der Sensordaten dient.

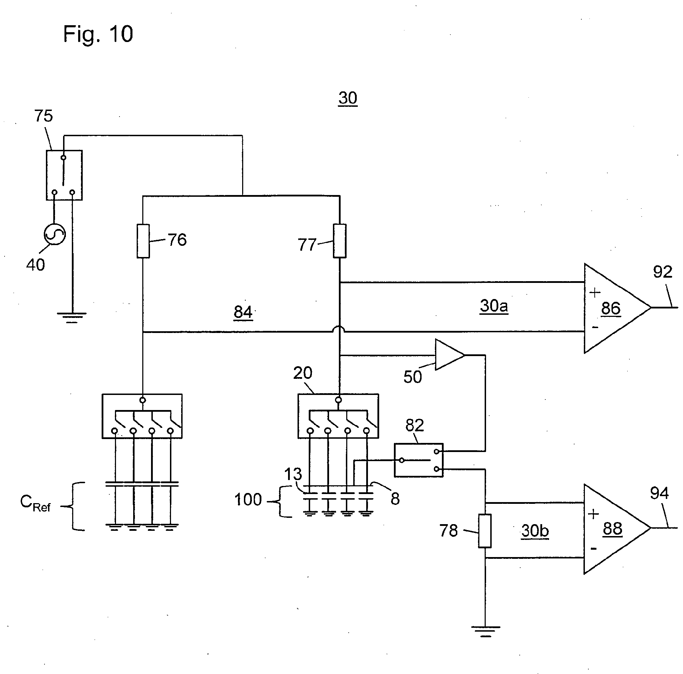

Die **Figur 10** zeigt ein schematisches Schaltdiagramm der analogen Mess- bzw. Auswerteeinheit 30 eines Sensormoduls gemäß einer bevorzugten Ausführungsform. Die Messeinheit 30 weist eine erste Kapazitätsmesseinrichtung 30a mit einer Messbrücke 84 zur Erfassung von Annäherungs-Messdaten, d.h. zur Durchführung der Näherungsmessung, auf. Die Messbrücke 84 umfasst einen ersten Messbrückenwiderstand 76, einen zweiten Messbrückenwiderstand 77 und eine Referenzkapazität C_{Ref}. Mit Hilfe der Messbrücke 84 kann die aus dem Sensorelement 100 und einem sich annähernden Objekt entstehende Kapazität am rechten Zweig der Messbrücke 84 durch einen Vergleich mit der Referenzkapazität C_{Ref} am linken Zweig der Messbrücke 84 bestimmt werden.

Im Rahmen der Erfindung hat sich gezeigt, dass durch Bauteile auf der Messstrecke, wie z.B. durch den Mehrfachschalter 20, nicht vernachlässigbare Streukapazitäten eingeführt werden können. Mit Hilfe der oben beschriebenen Brückenschaltung kann eine Verfälschung der Messergebnisse aufgrund solcher Streukapazitäten vermieden werden. Zudem können Drift-Effekte zumindest teilweise kompensiert werden.

Die Messeinheit 30 weist ferner eine zweite Kapazitätsmesseinrichtung 30b mit einem Messwiderstand 78 zur Erfassung von Taktilitäts-Messdaten auf. Weiterhin weist die Messeinheit 30 einen Spannungsfolger 50 auf, der in der selbst-kapazitiven Annäherungskonfiguration und/oder in der beidseitig-kapazitiven Annäherungskonfiguration mit der Bodenelektrode 8 des Sensorelements 100 verbunden wird.

Mit Hilfe eines ersten Konfigurationsschalters 75 kann die Messbrücke 84 entweder mit einer Erregersignalerzeugungseinheit bzw. Wechselspannungsquelle 40 oder mit Masse verbunden werden. Mit Hilfe des zweiten Konfigurationsschalters 82 kann die Bodenelektrode 8 des Sensorelements 100 entweder mit dem Messwiderstand 78 oder mit dem Spannungsfolger 50 verbunden werden. Insbesondere dient der erste Konfigurationsschalter 75 zum Umschalten zwischen Sendemodus und Empfangsmodus. Der zweite Konfigurationsschalter 82 dient zum Umschalten zwischen der taktilen Konfiguration und der Annäherungskonfiguration.

Die Messeinheit 30 kombiniert alle drei Mess-Modi, d.h. Sende-Modus, Empfangs-Modus und Taktil-Modus in einer Schaltung. Insbesondere kann das Sensorelement 100 mit Hilfe der Messeinheit 30 im Sendemodus, d.h. in einer selbst-kapazitiven Konfiguration, oder im Empfangsmodus, d.h. in einer beidseitig-kapazitiven Konfiguration, betrieben werden.

Für die Annäherungsmessung wird die Bodenelektrode 8 des Sensorelements 100 über den zweiten Konfigurationsschalter 82 als Schirmelektrode betrieben. Insbesondere wird sowohl in dem Sende- und Empfangsmodus der Annäherungsmessung die Bodenelektrode 8 an ein Schirmsignal angeschlossen, das aus zumindest einer Deckelelektrode 13 entnommen wird und mit einem Spannungsfolger 50 verstärkt wird. Damit liegt an der zumindest einen Deckelelektrode 13 und der Bodenelektrode 8 dasselbe Potential, wodurch die zumindest eine Deckelelektrode 13 von der Auswerteelektronik abgeschirmt ist. Im Sendemodus leitet der erste Konfigurationsschalter 75 das Erregersignal der Erregersignalerzeugungseinheit 40 an die zumindest eine Deckelelektrode 13. Im Empfangsmodus hingegen, d.h. wenn das Sensorelement 100 als Empfänger betrieben wird, wird die Messbrücke 84 über den ersten Konfigurationsschalter 75 mit Masse verbunden.

Für die taktile Messung wird die Bodenelektrode 8 des Sensorelements 100 durch den zweiten Konfigurationsschalter 82 über den Messwiderstand 78 an Masse angeschlossen. In diesem Fall hat ein Objekt im Messraum vernachlässigbaren Einfluss auf die Messung. Der erste Konfigurationsschalter 75 leitet im taktilen Modus das Erregersignal der Erregersignalerzeugungseinheit 40 an zumindest eine, mit dem Mehrfachschalter 20 ausgewählte, Deckelelektrode 13.

Das von der Messeinheit 30 mit Hilfe eines Operationsverstärkers 86 erzeugte Ausgangssignal 92 der Näherungsmessung und das mit Hilfe eines Operationsverstärkers 88 erzeugte Ausgangssignal 94 der taktilen Messung werden anschließend digitalisiert und mit Hilfe eines Mikrocontrollers demoduliert. Wahlweise kann in anderen Ausführungen ein Teil der Demodulation auch im analogen Bereich gelöst werden.

Die analoge Messschaltung 30 realisiert hauptsächlich eine Verstärkung der Stromänderung, welche durch die Kapazitätsänderung in den oben beschriebenen Szenarien bzw. Betriebsmodi hervorgerufen wird. Dabei wird der Einfluss von Streukapazitäten, welche z.B. durch den Mehrfachschalter 20 entstehen, gezielt eliminiert.

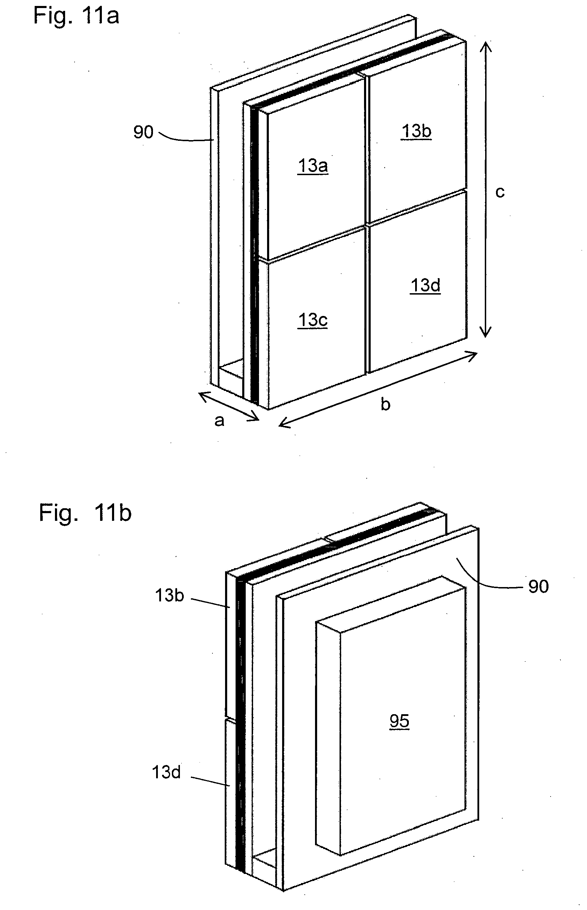

Die **Figur 11a** zeigt eine schematische Skizze eines Sensormoduls gemäß einer beispielhaften Ausführungsform der vorliegenden Erfindung in einer perspektivischen Vorderansicht. Auf der Vorderseite des Moduls sind vier Deckelelektroden 13a bis 13d zu sehen. Die Elektronik kann sich, wie in diesem Ausführungsbeispiel gezeigt, auf einer Leiterplatte bzw. einem PCB-Board 90 direkt hinter dem Sensorelement befinden. Alternativ ist es aber auch möglich, dass sich die Elektronik entfernt vom Sensorelement befindet, z.B. um die Dicke des Sensorelements zu reduzieren. In dem gezeigten Ausführungsbeispiel weist das Sensormodul eine Dicke a von ca. 10 mm, eine Breite b von ca. 40 mm und eine Länge c von ca. 40 mm auf.

In der **Figur 11b** ist das Sensormodul der **Figur 11a** in einer perspektivischen Rückansicht gezeigt, wobei elektronische Bauteile bzw. Schaltungen 95, die auf der Leiterplatte 90 angeordnet sind, schematisch angedeutet sind.

Jedes Sensormodul weist vorzugsweise eine eigene Steuer und/oder Messeinheit auf. Mehrere Sensormodule können durch Zusammenschalten ein Netz an Sensoren bilden.

Ausgehend von einem vernetzten Sensorsystem bestehend aus mehreren Sensormodulen, kann durch ein intelligentes Abtasten und Zusammenfassen von einzelnen Deckelelektroden, die auch als Pixelelemente bezeichnet werden können, eine höhere Reichweite bei Beibehalten der Ortsauflösung erreicht werden. Dazu werden mit Hilfe des weiter oben beschriebenen Mehrfachschalters 20 mehrere Deckelelektroden bzw. Pixelelemente zu einem größeren Pixelelement zusammengeschaltet, um die Reichweite zu erhöhen.

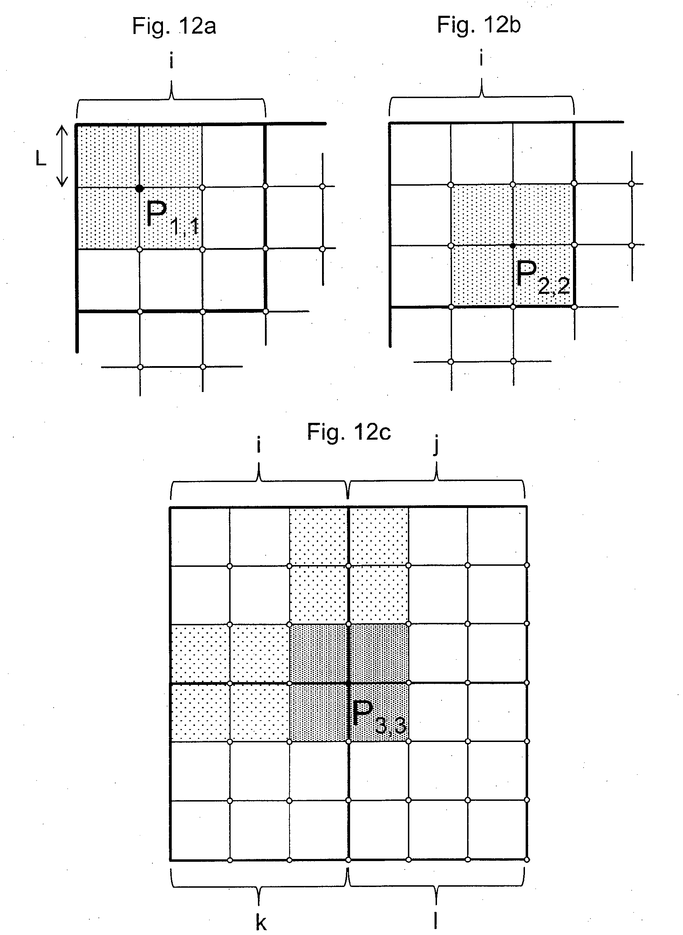

Die **Figuren 12a bis 12c** zeigen schematische Skizzen zu einem solchen intelligenten Zusammenfassen und Abtasten einzelner Deckelelektroden in einem vernetzten Sensorsystem. Ein Sensormodul i bzw. j umfasst in dem gezeigten Beispiel 3 × 3 Deckelelektroden. Jeweils 2 × 2 Deckelelektroden sind zu einem größeren Pixelelement zusammengeschaltet, welches in den Figuren 12a bis 12c jeweils durch eine punktierte Fläche dargestellt ist. Der Mittelpunkt eines solch größeren Pixelelements ist jeweils mit P_{x,y} bezeichnet, wobei x und y jeweils einen Wert von 1, 2 oder 3 haben kann.

Wie durch die **Figuren 12a und 12b** veranschaulicht, wird das resultierte größere Pixelelement nach Durchführung eines Messzyklus um ein Pixel der Länge L verschoben und die Messung wiederholt, womit eine Pseudo-Ortsauflösung realisiert wird. Durch die Verschiebung des zusammengeschalteten größeren Pixelelements um Vielfache der kleinsten Pixellänge L entstehen an den Gitterpunkten jeweils Messungen mit höherer Reichweite im Vergleich zu einem einzelnen kleinen Pixelelement, wobei jedoch die Ortsauflösung vorteilhafterweise gleich bleibt. Insbesondere kann ein Algorithmus aus den Messungen die ursprüngliche Ortsauflösung rekonstruieren. Zu berücksichtigen ist hierbei allerdings, dass durch diese Methode die Ortsauflösung direkt am Rande des vernetzten Sensorsystems nicht zu rekonstruierten ist. Um diesen Vorteil in einer vernetzten Haut ausnutzen zu können, müssen einzelne Deckelelektroden von anliegenden Modulen an beide Module angeschlossen sein.

In der **Figur 12c** wird illustriert, welche Deckelelektroden benachbarter Module i, j, k und l für das Durchführen einer Messung gleichzeitig verwendet werden müssen, um eine vollständige Abdeckung mit der Pseudo-Ortsauflösung zu erreichen. Die Elektroden im schraffierten Bereich sind an Modul i angeschlossen, wobei einige davon zu den anliegenden Modulen j, k und l gehören. Somit kann die Pseudo-Ortsauflösung im gesamten schraffierten Bereich, insbesondere im dunkelschraffierten Bereich, in dem Deckelelektroden aus mehreren Modulen vorkommen, erreicht werden. Es ist hervorzuheben, dass der zeitliche Aufwand, im Vergleich zum Auswählen einzelner Deckelelektroden für die gleiche Ortsauflösung, identisch ist. Um also in einem Netz aus mehreren Sensormodulen eine Pseudo-Ortsauflösung zu realisieren, müssen an den Übergängen zwischen den Modulen die Deckelelektroden der jeweiligen Module zusammengeschaltet werden können. Dazu ist es notwendig, dass manche Deckelelektroden an dem Messkanal oder den Messkanälen von beiden anliegenden Modulen angeschlossen sind.

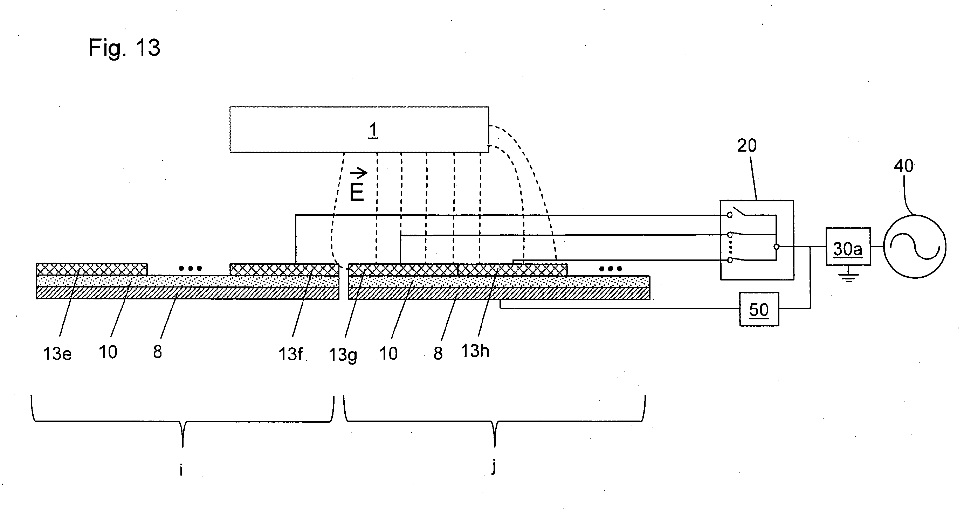

In der **Figur 13** sind schematisch zwei anliegende Sensormodule i und j sowie ein Objekt 1 gezeigt, wobei durch eine Messung an den zusammengeschalteten Elektroden 13g und 13h von Modul j das Objekt 1 detektiert wird.

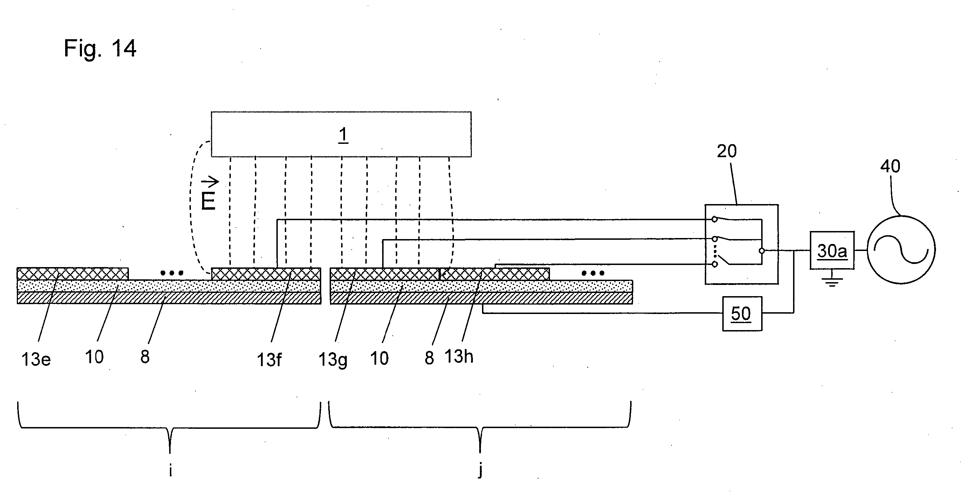

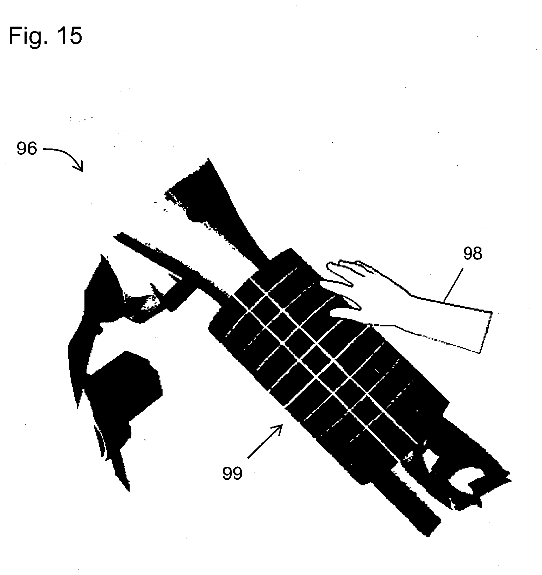

In der **Figur 14** sind wieder schematisch die anliegenden Module i und j sowie das Objekt 1 gezeigt, wobei durch eine Messung an den zusammengeschalteten Elektroden 13f von Modul i und 13g von Modul j das Objekt 1 ebenfalls detektiert wird. Die Objektposition bezüglich des Sensometzwerks ist so auch am Übergang zwischen den Modulen i und j mit hoher Reichweite zu erfassen. Es ist zu bemerken, dass die Sensormodule i und j prinzipiell identisch aufgebaut sein können. Somit ist die Darstellung hier auf eine beliebige Anzahl verketteter Module verallgemeinerbar. Die **Figur 15** zeigt eine schematische Skizze zur Verwendung der erfindungsgemäßen Sensormodule bzw. Sensorelemente 100 als Sensorhaut 99 eines Roboters 96 zur Detektion einer Annäherung und/oder zur kraftaufgelösten Detektion einer Berührung eines Objekts, wie z.B. einer Hand 98. Das erfindungsgemäße Sensormodul kann beide Modalitäten, nämlich eine taktile Detektion und eine Annäherungsdetektion, auf einer einzigen Fläche umsetzen.

Eine mit den erfindungsgemäßen Sensoren abgedeckte Oberfläche ist somit empfindlich für Annäherung und taktile Ereignisse. Die Näherungsmodalität weist eine Reichweite von mehr als 5 cm auf, so dass eine frühzeitige Reaktion auf Näherungsereignisse möglich ist.

Das erfindungsgemäße Sensormodul kann die Ereignisse nicht nur detektieren, sondern auch lokalisieren. Dafür weist das erfindungsgemäße Sensormodul eine geeignete Ortsauflösung, z.B. ein Sensorelement pro 9 mm², auf. Um Ereignisse, wie z.B. Bewegungen des Menschen oder Bewegungen anderer Objekte im Automatisierungsumfeld zu erfassen, können mit dem erfindungsgemäßen Sensor eine Latenz von < 20 ms, vorzugsweise < 10 ms und eine Mess-Wiederholrate von > 50 Hz erreicht werden. Die erfindungsgemäßen Sensormodule sind flexibel an unterschiedlichen Geometrien einer vorgegebenen mechanischen Struktur anpassbar, um diese abzudecken. Es wird angemerkt, dass die oben angegebenen Werte zur Latenz und Mess-Wiederholrate insbesondere von der Konfiguration des Sensors abhängen.

Insbesondere weist das erfindungsgemäße Sensormodul, abhängig von der jeweiligen Ausführungsform, die folgenden vorteilhaften Eigenschaften auf:
Der Sensor bzw. das Sensormodul ist multifunktional, d.h. in der Lage, annähernde Objekte zu detektieren und im Berührungsfall die Druckkraft aufzulösen. Durch die Trennung der taktilen und der Näherungsmessschaltung voneinander, sowie durch den modularen Aufbau des Sensors, ist der Sensor in der Lage, die Druckkraft eines oder mehrerer Objekte zu erfassen und gleichzeitig die Annäherung eines weiteren oder mehrerer Objekte zu detektieren.

Bedingt durch das kapazitive Messprinzip und die Ausbreitung der elektrischen Felder, können Ereignisse vor einem Sensorelement, sowie rund um das Sensorelement detektiert werden.

Das Sensormodul hat sowohl für die Annäherungsmessung als auch für die taktile Messung eine Ortsauflösung, die durch die Unterteilung der Deckelelektroden definiert ist. Diese stellen individuelle Messelektroden bzw. Pixel dar.

Bedingt durch das kapazitive Messprinzip muss bei einem Näherungssensor in der Regel ein Kompromiss zwischen Größe der Sensorelemente (Ortsauflösung) und Reichweite eingegangen werden. Durch die erfindungsgemäßen Sensormodule ist es durch ein dynamisches Zusammenschalten von Deckelelektroden möglich, die Reichweite bei gleichbleibender Ortsauflösung zu erhöhen.

Durch ein direktes ohmsches Kurzschließen der einzelnen Deckelelektroden sind beliebige Elektrodenformen ohne Zeit-Multiplexen realisierbar.

Deckelelektroden, welche für die selbst-kapazitive Näherungsmessung zuständig sind, können gleichzeitig als Sende-Elektroden für die beidseitig-kapazitive taktile Konfiguration, d.h. für den taktilen Modus, verwendet werden. Dadurch wird eine schaltungsgünstige Bi-Modalität erzielt.

Durch den erfindungsgemäßen Aufbau des Sensorelements fungiert die Bodenelektrode als Empfangs-Elektrode während der taktilen Messung und als Schirmelektrode während der Annäherungsmessung. Zwischen den beiden Modi kann dynamisch umgeschaltet werden.

In der selbst-kapazitiven Konfiguration und durch eine direkte Messung des Sendestroms kann die Erregersignal-Schaltung (Treiber) und die Messschaltung in einer gemeinsamen Elektronik integriert werden.

Unter Verwendung der Tiefpass-Messmethode zur Kapazitätsmessung sind beide kapazitiven Konfigurationen, d.h. die selbst- und die beidseitig-kapazitive Konfiguration, möglich. Somit ist auch die Detektion von sich annähernden elektrisch leitenden und nichtleitenden Objekten möglich.

Zur Eliminierung von parasitären kapazitiven Kopplungen kann ein Schirmsignal verwendet werden. Zur Erhöhung des Messbereiches können statische und dynamische parasitäre Kapazitäten durch den Einsatz von Vergleichsmessungen (Messbrücke) kompensiert werden.

Die Sensorelemente, über die die elektrischen Phänomene ausgenutzt werden, sind Elektroden. Als solche kommen beliebige Flächengrößen und -formen aus leitenden Materialien in Frage. Sinnvolle Elektrodengrößen sind vereinbar mit einer vollintegrierten Analog-/Digital- Elektronik.

Die Sensorelemente können örtlich von der Auswerteelektronik getrennt sein, was eine einfache Integration in unterschiedlichen Situationen ermöglicht.

Es können Erregersignale verschiedener Frequenzen verwendet werden. Da im Allgemeinen jedes Material eine bestimmte Primitivität aufweist, die von der Frequenz des Erregersignals abhängt, ist es durch die Verwendung verschiedener Erregersignalfrequenzen möglich, das Material von detektierten Objekten zu identifizieren.

Mehrere Module können auf einfache Weise zu einer sensorischen Haut zusammengeschlossen und synchronisiert werden.

Durch die integrierten Methoden zur Signalverarbeitung ist eine geringe Latenz und hohe Taktrate gewährleistet.

Das Sensormodul ist für den Niederspannungsbetrieb ausgelegt und kann z.B. mit einer Spannung von 3 V versorgt werden, was günstig hinsichtlich des Stromverbrauchs und der elektromagnetischen Verträglichkeit ist.

### Bezugszeichenliste

- 1: Objekt / Gegenstand
- 2: Objekt / Gegenstand
- 3: Elektrode
- 3a: Elektrode / Sender
- 3b: Elektrode / Empfänger
- 4: Schirm / Schirmplatte
- 8: Bodenelektrode
- 10: Schaumstoffschicht / zweite Schicht
- 13: Deckelelektrode
- 13a-13h: Deckelelektrode
- 15: externe Quelle
- 17: Isolationsschicht
- 19: Isolationsschicht
- 20: Mehrfachschalter
- 30: Messeinheit / Messstrecke
- 40: Erregersignalerzeugungseinheit / Spannungsquelle
- 50: Spannungsfolger
- 60: Kontrollregister
- 61: Multiplexer
- 65: Anti-Aliasing Filter
- 66: Analog-Digital-Wandler
- 67: digitaler Filter
- 68: Amplitudenmodulationseinheit
- 69: Distanzberechnungseinheit
- 70: Bus-System
- 75: erster Konfigurationsschalter
- 76: Messbrückenwiderstand
- 77: Messbrückenwiderstand
- 78: Messwiderstand
- 82: zweiter Konfigurationsschalter
- 84: Messbrücke
- 86: Operationsverstärker
- 88: Operationsverstärker
- 90: Leiterplatte
- 92: Ausgang bzw. Ausgangssignal der Annäherungsmessung
- 94: Ausgang bzw. Ausgangssignal der taktilen Messung
- 95: Elektronische Bauteile / Schaltung
- 96: Roboter
- 98: Hand
- 100: Sensorelement

## Patentansprüche

1. Sensormodul zum kapazitiven und ortsaufgelösten Detektieren der Annäherung eines Objekts (1) an das Sensormodul und zum kapazitiven und ortsaufgelösten Erfassen von taktilen Ereignissen zwischen einem Objekt (1) und dem Sensormodul, umfassend
- ein Sensorelement (100), welches eine erste, zweite und dritte Schicht aufweist, wobei die erste Schicht eine Vielzahl von elektrisch leitfähigen Deckelelektroden (13) umfasst, wobei die zweite Schicht (10) verformbar und elektrisch isolierend ist, wobei die dritte Schicht eine elektrisch leitfähige Bodenelektrode (8) aufweist, wobei die zweite Schicht zwischen der ersten und dritten Schicht angeordnet ist, wobei die erste und dritte Schicht die einzigen elektrisch leitfähigen Schichten des Sensorelements (100) sind, und
- eine Messeinheit (30), welche ausgelegt ist, das Sensorelement (100) in drei verschiedenen Mess-Konfigurationen, nämlich in einer selbst-kapazitiven Annäherungskonfiguration, einer beidseitig-kapazitiven Annäherungskonfiguration und einer beidseitig-kapazitiven Taktilitätskonfiguration, zu betreiben, wobei die Messeinheit (30) ausgelegt ist:
-- in der selbst-kapazitiven Annäherungskonfiguration zumindest eine der Deckelelektroden (13) in einem Sendemodus zu betreiben;
-- in der beidseitig-kapazitiven Annäherungskonfiguration die zumindest eine Deckelelektrode (13) im Sendemodus oder in einem Empfangsmodus zu betreiben; und
-- in der beidseitig-kapazitiven Taktilitätskonfiguration die zumindest eine Deckelelektrode (13) im Sendemodus und die Bodenelektrode (8) im Empfangsmodus zu betreiben.

2. Sensormodul nach Anspruch 1, wobei das Sensormodul einen Mehrfachschalter (20) aufweist,
wobei jede einzelne Deckelelektrode (13) durch den Mehrfachschalter (20) ansteuerbar ist, und/oder
wobei zwei oder mehrere Deckelelektroden (13) elektrisch miteinander verbunden werden können.

3. Sensormodul nach Anspruch 1 oder 2, wobei die Messeinheit (30) ausgelegt ist, Annäherungs-Messdaten in der selbst-kapazitiven Annäherungskonfiguration und in der beidseitig-kapazitiven Annäherungskonfiguration zu erfassen, und wobei die Messeinheit (30) ferner ausgelegt ist, Taktilitäts-Messdaten in der beidseitig-kapazitiven Taktilitätskonfiguration zu erfassen.

4. Sensormodul nach einem der vorangehenden Ansprüche, wobei die Messeinheit (30) eine Erregersignalerzeugungseinheit (40), eine erste Kapazitätsmesseinrichtung (30a) und eine zweite Kapazitätsmesseinrichtung (30b) aufweist, wobei:
- in der selbst-kapazitiven Annäherungskonfiguration zumindest eine der Deckelelektroden (13) sowohl mit der Erregersignalerzeugungseinheit (40) als auch mit der ersten Kapazitätsmesseinrichtung (30a) verbunden ist;
- in der beidseitig-kapazitiven Annäherungskonfiguration die zumindest eine Deckelelektrode (13) mit der ersten Kapazitätsmesseinrichtung (30a) verbunden ist; und
- in der beidseitig-kapazitiven Taktilitätskonfiguration die zumindest eine Deckelelektrode (13) mit der Erregersignalerzeugungseinheit (40) verbunden ist und die Bodenelektrode (8) mit der zweiten Kapazitätsmesseinrichtung (30b) verbunden ist.

5. Sensormodul nach einem der vorangehenden Ansprüche, wobei die Messeinheit (30) ausgelegt ist, in der selbst-kapazitiven Annäherungskonfiguration und in der beidseitig-kapazitiven Annäherungskonfiguration eine Kapazität oder eine Änderung der Kapazität zwischen zumindest einer Deckelelektrode (13) und dem Objekt (1) zu messen, und wobei die Messeinheit (30) ausgelegt ist, in der beidseitig-kapazitiven Taktilitätskonfiguration eine Kapazität oder eine Änderung der Kapazität zwischen der zumindest einen Deckelelektrode (13) und der Bodenelektrode (8) zu messen.

6. Sensormodul nach einem der vorangehenden Ansprüche,
wobei die Messeinheit (30) eine Messbrücke (84) zur Erfassung der Annäherungs-Messdaten aufweist, und/oder
wobei die Messeinheit (30) einen Messwiderstand (78) zur Erfassung der Taktilitäts-Messdaten aufweist, und/oder
wobei die Messeinheit (30) einen Spannungsfolger (50) aufweist, wobei der Spannungsfolger (50) in der selbst-kapazitiven Annäherungskonfiguration und/oder in der beidseitig-kapazitiven Annäherungskonfiguration mit der Bodenelektrode (8) verbunden ist.

7. Sensormodul nach einem der vorangehenden Ansprüche, wobei die Messeinheit (30) eine Messbrücke (84) zur Erfassung der Annäherungs-Messdaten aufweist und wobei die Messeinheit (30) ferner einen ersten Konfigurationsschalter (75) aufweist, mit dem die Messbrücke (84) entweder mit einer Erregersignalerzeugungseinheit (40) oder mit Masse verbunden werden kann.

8. Sensormodul nach einem der vorangehenden Ansprüche, wobei die Messeinheit (30) einen Messwiderstand (78) zur Erfassung der Taktilitäts-Messdaten und einen Spannungsfolger (50) aufweist, und wobei die Messeinheit (30) ferner einen zweiten Konfigurationsschalter (82) aufweist, mit dem die Bodenelektrode (8) entweder mit dem Messwiderstand (78) oder mit dem Spannungsfolger (50) verbunden werden kann.

9. Sensorsystem umfassend eine Vielzahl von Sensormodulen nach einem der vorangehenden Ansprüche.

10. Sensorsystem nach Anspruch 9,
wobei die Sensormodule zu einem Array angeordnet sind, und/oder
wobei die Sensormodule eine Messeinheit (30) aufweisen, welche ausgelegt ist, jeweils zwei aneinandergrenzende Cluster von Deckelelektroden der Vielzahl von Sensormodulen zusammenzuschalten.

11. Verfahren zum kapazitiven und ortsaufgelösten Detektieren der Annäherung eines Objekts (1) und zum kapazitiven und ortsaufgelösten Erfassen von taktilen Ereignissen, umfassend die Schritte:
- Bereitstellen eines oder mehrerer Sensormodule nach einem der Ansprüche 1 bis 8 oder Bereitstellen eines Sensorsystems nach Anspruch 9 oder 10;
- Betreiben der Sensorelemente (100) in der selbst-kapazitiven Annäherungskonfiguration oder der beidseitig-kapazitiven Annäherungskonfiguration und Erfassen von Annäherungs-Messdaten, und/oder
- Betreiben der Sensorelemente (100) in der beidseitig-kapazitiven Taktilitätskonfiguration und Erfassen von Taktilitäts-Messdaten.

12. Verfahren nach Anspruch 11, wobei die Sensorelemente (100) abwechselnd in der selbst-kapazitiven Annäherungskonfiguration, in der beidseitig-kapazitiven Annäherungskonfiguration und in der beidseitig-kapazitiven Taktilitätskonfiguration betrieben werden.

13. Verwendung eines Sensormoduls nach einem der Ansprüche 1 bis 8 oder eines Sensorsystems nach Anspruch 9 oder 10
- als taktiler Näherungssensor in funktionalen Oberflächen, und/oder
- zur Ausbildung einer Sensorhaut (99) in der Robotik.

## Claims

1. A sensor module for the capacitive and spatially resolved detection of an object (1) approaching the sensor module and for the capacitive and spatially resolved capturing of tactile events between an object (1) and the sensor module, comprising
- a sensor element (100) which has a first, a second and a third layer, wherein the first layer comprises a plurality of electrically conductive top electrodes (13), wherein the second layer (10) is deformable and electrically insulating, wherein the third layer has an electrically conductive bottom electrode (8), wherein the second layer is arranged between the first and third layers, wherein the first and third layers are the only electrically conductive layers of the sensor element (100), and
- a measuring unit (30) which is designed to operate the sensor element (100) in three different measurement configurations, namely in a self-capacitive approach configuration, a bilateral-capacitive approach configuration and a bilateral-capacitive tactility configuration, wherein the measuring unit (30) is designed:
-- in the self-capacitive approach configuration, to operate at least one of the top electrodes (13) in a transmit mode;
-- in the bilateral-capacitive approach configuration, to operate the at least one top electrode (13) in the transmit mode or in a receive mode; and
-- in the bilateral-capacitive tactility configuration, to operate the at least one top electrode (13) in the transmit mode and the bottom electrode (8) in the receive mode.

2. The sensor module according to Claim 1, wherein the sensor module has a multiple switch (20),
wherein each individual top electrode (13) can be actuated by the multiple switch (20), and/or
wherein two or more top electrodes (13) can be electrically connected to each other.

3. The sensor module according to Claim 1 or 2, wherein the measuring unit (30) is designed to capture approach measurement data in the self-capacitive approach configuration and in the bilateral-capacitive approach configuration, and wherein the measuring unit (30) is further designed to capture tactility measurement data in the bilateral-capacitive tactility configuration.

4. The sensor module according to any one of the preceding claims, wherein the measuring unit (30) has an excitation signal generating unit (40), a first capacitance measuring apparatus (30a) and a second capacitance measuring apparatus (30b), wherein:
- in the self-capacitive approach configuration, at least one of the top electrodes (13) is connected both to the excitation signal generating unit (40) and to the first capacitance measuring apparatus (30a);
- in the bilateral-capacitive approach configuration, the at least one top electrode (13) is connected to the first capacitance measuring apparatus (30a);
and
- in the bilateral-capacitive tactility configuration, the at least one top electrode (13) is connected to the excitation signal generating unit (40) and the bottom electrode (8) is connected to the second capacitance measuring apparatus (30b).

5. The sensor module according to any one of the preceding claims, wherein the measuring unit (30) is designed, in the self-capacitive approach configuration and in the bilateral-capacitive approach configuration, to measure a capacitance or a change in the capacitance between at least one top electrode (13) and the object (1), and wherein the measuring unit (30) is designed, in the bilateral-capacitive tactility configuration, to measure a capacitance or a change in the capacitance between the at least one top electrode (13) and the bottom electrode (8).

6. The sensor module according to any one of the preceding claims,
wherein the measuring unit (30) has a measuring bridge (84) for capturing the approach measurement data, and/or
wherein the measuring unit (30) has a measuring resistor (78) for capturing the tactility measurement data, and/or
wherein the measuring unit (30) has a voltage follower (50), wherein the voltage follower (50) is connected, in the self-capacitive approach configuration and/or in the bilateral-capacitive approach configuration, to the bottom electrode (8).

7. The sensor module according to any one of the preceding claims, wherein the measuring unit (30) has a measuring bridge (84) for capturing the approach measurement data, and wherein the measuring unit (30) further has a first configuration switch (75), with which the measuring bridge (84) can be connected either to an excitation signal generating unit (40) or to ground.

8. The sensor module according to any one of the preceding claims, wherein the measuring unit (30) has a measuring resistor (78) for capturing the tactility measurement data and a voltage follower (50), and wherein the measuring unit (30) further has a second configuration switch (82), with which the bottom electrode (8) can be connected either to the measuring resistor (78) or to the voltage follower (50).

9. A sensor system comprising a plurality of sensor modules according to any one of the preceding claims.

10. The sensor system according to Claim 9,
wherein the sensor modules are arranged in an array, and/or
wherein the sensor modules have a measuring unit (30) which is designed to interconnect in each case two clusters of top electrodes, which are adjacent to one another, of the plurality of sensor modules.

11. A method for the capacitive and spatially resolved detection of the approach of an object (1) and for the capacitive and spatially resolved capturing of tactile events, comprising the steps of:
- providing one or more sensor modules according to any one of Claims 1 to 8 or providing a sensor system according to Claim 9 or 10;
- operating the sensor elements (100) in the self-capacitive approach configuration or the bilateral-capacitive approach configuration and capturing approach measurement data, and/or
- operating the sensor elements (100) in the bilateral-capacitive tactility configuration and capturing tactility measurement data.

12. The method according to Claim 11, wherein the sensor elements (100) are operated alternately in the self-capacitive approach configuration, in the bilateral-capacitive approach configuration and in the bilateral-capacitive tactility configuration.

13. Use of a sensor module according to any one of Claims 1 to 8 or of a sensor system according to Claim 9 or 10
- as a tactile proximity sensor in functional surfaces, and/or
- in order to form a sensor skin (99) in robotics.

## Revendications

1. Module capteur pour la détection capacitive et à résolution spatiale de l'approche d'un objet (1) par rapport au module capteur et pour la détermination capacitive et à résolution spatiale d'événements tactiles entre un objet (1) et le module capteur, comportant
- un élément capteur (100) présentant une première, une deuxième et une troisième couche, la première couche comportant une pluralité d'électrodes de recouvrement (13) électriquement conductrices, la deuxième couche (10) étant déformable et électriquement isolante, la troisième couche présentant une électrode de fond (8) électriquement conductrice, la deuxième couche étant disposée entre la première et la troisième couche, la première et la troisième couche étant les seules couches électriquement conductrices de l'élément capteur (100), et
- une unité de mesure (30) conçue pour faire fonctionner l'élément capteur (100) dans trois configurations de mesure différentes, notamment une configuration d'approche auto-capacitive, une configuration d'approche bilatéralement capacitive et une configuration de tactilité bilatéralement capacitive, l'unité de mesure (30) étant conçue pour :
- dans la configuration d'approche auto-capacitive, faire fonctionner l'une au moins des électrodes de recouvrement (13) dans un mode d'émission ;
- dans la configuration d'approche bilatéralement capacitive, faire fonctionner l'au moins une électrode de recouvrement (13) dans le mode d'émission ou dans un mode de réception ; et
- dans la configuration de tactilité bilatéralement capacitive, faire fonctionner l'au moins une électrode de recouvrement (13) dans le mode d'émission et l'électrode de fond (8) dans la mode de réception.

2. Module capteur selon la revendication 1, dans lequel le module capteur présente un commutateur multiple (20),
dans lequel chaque électrode de recouvrement (13) individuelle peut être commandée par le commutateur multiple (20), et/ou
dans lequel deux ou plusieurs électrodes de recouvrement (13) peuvent être connectées électriquement entre elles.

3. Module capteur selon la revendication 1 ou 2, dans lequel l'unité de mesure (30) est conçue pour collecter des données de mesure d'approche dans la configuration d'approche auto-capacitive et dans la configuration d'approche bilatéralement capacitive, et dans lequel l'unité de mesure (30) est en outre conçue pour collecter des données de mesure de tactilité dans la configuration de tactilité bilatéralement capacitive.

4. Module capteur selon l'une des revendications précédentes, dans lequel l'unité de mesure (30) présente une unité de génération de signaux d'excitation (40), un premier dispositif de mesure capacitif (30a) et un deuxième dispositif de mesure capacitif (30b) ; dans lequel :
- dans la configuration d'approche auto-capacitive, l'une au moins des électrodes de recouvrement (13) est connectée aussi bien à l'unité de génération de signaux d'excitation (40) qu'au premier dispositif de mesure capacitif (30a) ;
- dans la configuration d'approche bilatéralement capacitive, l'au moins une électrode de recouvrement (13) est connectée au premier dispositif de mesure capacitif (30a) ; et
- dans la configuration de tactilité bilatéralement capacitive, l'au moins une électrode de recouvrement (13) est connectée à l'unité de génération de signaux d'excitation (40) et l'électrode de fond (8) est connectée au deuxième dispositif de mesure capacitif (30b).

5. Module capteur selon l'une des revendications précédentes, dans lequel l'unité de mesure (30) est conçue pour mesurer, dans la configuration d'approche auto-capacitive et dans la configuration d'approche bilatéralement capacitive, une capacité ou une modification de la capacité entre au moins une électrode de recouvrement (13) et l'objet (1), et dans lequel l'unité de mesure (30) est conçue pour mesurer, dans la configuration de tactilité bilatéralement capacitive, une capacité ou une modification de la capacité entre l'au moins une électrode de recouvrement (13) et l'électrode de fond (8).

6. Module capteur selon l'une des revendications précédentes,
dans lequel l'unité de mesure (30) présente un pont de mesure (84) pour la collecte des données de mesure d'approche, et/ou
dans lequel l'unité de mesure (30) présente une résistance de mesure (78) pour la collecte des données de mesure de tactilité, et/ou
dans lequel l'unité de mesure (30) présente un suiveur de tension (50), le suiveur de tension (50) étant connecté à l'électrode de fond (8) dans la configuration d'approche auto-capacitive et/ou dans la configuration d'approche bilatéralement capacitive.

7. Module capteur selon l'une des revendications précédentes, dans lequel l'unité de mesure (30) présente un pont de mesure (84) pour la collecte des données de mesure d'approche et dans lequel l'unité de mesure (30) présente en outre un premier commutateur de configuration (75) permettant de connecter le pont de mesure (84) soit à l'unité de génération de signaux d'excitation (40), soit à la masse.

8. Module capteur selon l'une des revendications précédentes, dans lequel l'unité de mesure (30) présente une résistance de mesure (78) pour la collecte des données de mesure de tactilité et un suiveur de tension (50), et dans lequel l'unité de mesure (30) présente un outre un deuxième commutateur de configuration (82) permettant de connecter l'électrode de fond (8) soit à la résistance de mesure (78), soit au suiveur de tension (50).

9. Système de capteur comportant une pluralité de modules capteurs selon l'une des revendications précédentes.

10. Système de capteur selon la revendication 9,
dans lequel les modules capteurs sont disposés en réseau, et/ou
dans lequel les modules capteurs présentent une unité de mesure (30) conçue pour interconnecter respectivement deux clusters adjacents d'électrodes de recouvrement de la pluralité de modules capteurs.

11. Procédé de détection capacitive et à résolution spatiale de l'approche d'un objet (1) et pour la détermination capacitive et à résolution spatiale d'événements tactiles, comportant les étapes suivantes :
- mise à disposition d'un ou de plusieurs modules capteurs selon l'une des revendications 1 à 8 ou mise à disposition d'un système de capteur selon la revendication 9 ou 10 ;
- fonctionnement des éléments capteurs (100) dans la configuration d'approche auto-capacitive ou dans la configuration d'approche bilatéralement capacitive et collecte de données de mesure d'approche, et/ou
- fonctionnement des éléments capteurs (100) dans la configuration de tactilité bilatéralement capacitive et collecte de données de mesure de tactilité.

12. Procédé selon la revendication 11, dans lequel les éléments capteurs (100) fonctionnent alternativement dans la configuration d'approche auto-capacitive, dans la configuration d'approche bilatéralement capacitive et dans la configuration de tactilité bilatéralement capacitive.

13. Utilisation d'un module capteur selon l'une des revendications 1 à 8 ou d'un système de capteur selon la revendication 9 ou 10
- en tant que capteur d'approche tactile sur des surfaces fonctionnelles, et/ou
- pour la réalisation d'une peau formant capteur (99) dans la robotique.
